# EUROPEAN PATENT SPECIFICATION

(11) **EP 4 402 493 B1**
(45) Date of publication and mention of the grant of the patent: **12.08.2026**
(21) Application number: 21789937.6
(22) Date of filing: 14.09.2021
(51) Int. Cl.: G01R 21/133, G01R 19/25, G01R 15/18, G01R 15/20, G01R 21/06

(54) **POWER CORD DEVICE TO MONITOR EQUIPMENT**
STROMKABELVORRICHTUNG ZUR ÜBERWACHUNG EINES GERÄTS
DISPOSITIF DE CÂBLE D'ALIMENTATION POUR SURVEILLER UN ÉQUIPEMENT

(43) Date of publication of application: 24.07.2024
(73) Proprietor: Resideo LLC, Wilmington, DE 19808 (US)
(72) Inventor: COURTNEY, Brian Scott, Golden Valley, Minnesota 55422 (US); KNECHT, Brenden, Golden Valley, Minnesota 55422 (US)
(74) Representative: Murgitroyd & Company
(86) International application number: PCT/US2021/050261
(87) International publication number: WO 2023/043430

(56) References cited:
- EP-A1- 3 812 776
- US-A1- 2018 321 285

## Description

### TECHNICAL FIELD

The disclosure relates to systems and techniques for performing performance analysis of electrically powered equipment.

### BACKGROUND

People have different types of equipment in their home, such as air conditioners, pumps, furnaces, electronic devices (e.g., laptop computers, digital assistant devices, tablets, smart phones, etc.), refrigerators, other appliances, garage door openers, and the like. This equipment may use electricity to perform the desired function. Additionally, this equipment may include components that may fail and render the equipment inoperable or reduce the performance of the equipment. For example, when a blower motor on a furnace fails, the furnace is no longer able to transfer heat throughout a home. As another example, if the compressor on an air conditioner starts failing, the air conditioner is no longer able to provide cooling as efficiently. Performance monitoring of equipment may be useful to a household with such equipment.

Performance monitoring for equipment can be characterized in a variety of ways. One way is to monitor efficiency, e.g., energy input to energy output, run time, mean time between failure and so on. Another way may include monitoring the power characteristics, such as look at the power (watts), voltage-amperes reactive (vars) or electrical current (amperage) over time.

EP3812776A1 discloses a power consumption monitoring device that may be attached to any equipment.

### SUMMARY

In general, the disclosure describes a system that monitors and analyzes power consumption signals over time for household equipment. Equipment may exhibit a representative operating signature for the equipment. The system analytics may include determining a 'normal' operating signature for a piece of monitored equipment, which may include minimum and maximum expected ranges for different transition points or other characteristic points in the signature. The characteristic points may include points of minimum variability in magnitude. Based on monitoring the characteristic points, the system may make a binary determination of "normal" or "abnormal." In other words, the system may determine that an operational run of the equipment is good or "potentially not good," based on a comparison of the measured characteristics points to a normal operating signature. In response to a binary determination of abnormal, the system may output a signal to alert the equipment user, a repair facility, or similar entity about the potential abnormal behavior. The alert may allow the user to adjust, maintain or repair the monitored equipment before the equipment fails.

The system may include a power consumption monitoring device that may be attached to any electrically powered equipment. In some examples, the device may include a male and female electrical plug that may be inserted between the equipment and line power. In other examples, one or both ends of the device may be hard-wired to the equipment and or to line power. The device may include monitoring circuitry and a power cord "pigtail" with one or more wires shielded from the other wires to avoid canceling the inbound and outbound current. Also, part of the shielding, or other portion of the pigtail may act as an antenna to communicate between the monitoring circuitry and a gateway. The components of the device of this disclosure may be completely implemented within the power cord, such that performance monitoring can be performed on the equipment without the equipment itself including a monitoring device.

In one example, this disclosure describes a system configured to monitor electrically powered equipment, the system comprising a gateway, which includes a sensor configured to: measure electrical power consumed by the electrically powered equipment; and output a signal indicative of the electrical power consumed by the electrically powered equipment. The system also has a memory comprising computer readable storage media and second processing circuitry operatively coupled to the sensor and the memory. The second processing circuitry is configured to receive the signal; determine, from the signal, an indication of an operating signature for the electrically powered equipment, wherein the operating signature comprises a plurality of characteristic points; compare respective characteristic points of the plurality of characteristic points to respective thresholds for each characteristic point stored in the memory. In response to each characteristic point in the operating signature satisfying each respective threshold for the respective characteristic point the second processing circuitry may determine whether to output a message to the gateway; in response to the determination that no message is warranted, refrain from outputting a message.

In another example, this disclosure describes a method comprising: receiving, by processing circuitry of a performance monitoring device, an indication of an operating signature for electrically powered equipment from a sensor. The sensor is configured to measure electrical power consumed by the electrically powered equipment. The operating signature comprises a plurality of characteristic points. The method further includes comparing, by the processing circuitry, respective characteristic points of the plurality of characteristic points to respective thresholds for each characteristic point; in response to each characteristic point in the operating signature satisfying each respective threshold for the respective characteristic point, determining whether to output a message; in response to determining that no message is warranted, refraining from outputting the message.

In another example, this disclosure describes a device comprising a memory comprising computer readable storage media and processing circuitry operatively coupled to the memory; the processing circuitry configured to: receive a signal from sensing circuitry, the sensing circuitry configured to: measure electrical power consumed by electrically powered equipment and output the signal that includes an indication of an operating signature for the electrically powered equipment, wherein the operating signature comprises a plurality of characteristic points. The processing circuitry is further configured to compare respective characteristic points of the plurality of characteristic points to respective thresholds for each characteristic point stored at the memory; in response to each characteristic point in the operating signature satisfying each respective threshold for the respective characteristic point, determine whether to output a message to the gateway; and in response to the determination that no message is warranted, refrain from outputting the message.

According to an aspect of the invention, this disclosure describes a device comprising a plurality of electrical conductors configured to carry alternating current (AC) power; current sensing circuitry, wherein the current sensing circuitry is configured to output a signal identifying characteristics of a first electrical current traveling through a first electrical conductor of the plurality of electrical conductors; an electromagnetic shield, configured to isolate the current sensing circuitry from sensing a second electrical current traveling through a second electrical conductor of the plurality of electrical conductors, the second electrical conductor being different from the first electrical conductor; communication circuitry configured to communicate with an external computing device separate from the device; processing circuitry operatively coupled to the current sensing circuitry and a memory, the processing circuitry configured to: receive the signal from the current sensing circuitry; determine the characteristics of the first electrical current based on the signal; determine whether to cause the communication circuitry to output an electronic message based on the determined characteristics of the first electrical current; compare the determined characteristics to one or more threshold limits stored at the memory; based on the comparison, determine whether to output a message to the external computing device; and in response to the determination, refrain from causing the communication circuitry to output the message.

According to another aspect of the invention, this disclosure describes a system includes a gateway comprising first processing circuitry coupled to a memory, the gateway configured to communicate with a server as well as a device comprising a plurality of electrical conductors configured to carry alternating current (AC) power; current sensing circuitry, wherein the current sensing circuitry is configured to output a signal identifying characteristics of a first electrical current traveling through a first electrical conductor of the plurality of electrical conductors; an electromagnetic shield, configured to isolate the current sensing circuitry from sensing a second electrical current traveling through a second electrical conductor of the plurality of electrical conductors, the second electrical conductor being different from the first electrical conductor; communication circuitry configured to communicate with the gateway; second processing circuitry operatively coupled to the current sensing circuitry, the second processing circuitry configured to: receive the signal from the current sensing circuitry; determine the characteristics of the first electrical current based on the signal; cause the communication circuitry to output a message to the gateway, wherein the message includes the characteristics of the first electrical current; the first processing circuitry of the gateway is configured to: receive the message with the characteristics of the first electrical current; compare the determined characteristics to one or more threshold limits stored at the memory; based on the comparison, determine whether to output a message to the server; in response to the determination, refrain from outputting the message.

According to another aspect of the invention, this disclosure describes a method comprising outputting, by current sensing circuitry, a signal identifying characteristics of a first electrical current traveling through a first electrical conductor of a plurality of electrical conductors; receiving, by processing circuitry of a device, the signal from the current sensing circuitry, wherein the device comprises an electromagnetic shield, configured to isolate the current sensing circuitry from sensing a second electrical current traveling through a second electrical conductor of the plurality of electrical conductors, the second electrical conductor being different from the first electrical conductor; determining, by the processing circuitry, the determined characteristics of the first electrical current based on the received signal; comparing, by the processing circuitry, the determined characteristics to one or more threshold limits stored at the memory; based on the comparison, determining, by the processing circuitry, whether to cause communication circuitry coupled to the processing circuitry to output an electronic message based on the characteristics of the first electrical current; in response to the determination, refraining from causing the communication circuitry to output the message.

The details of one or more examples of the disclosure are set forth in the accompanying drawings and the description below. Other features, objects, and advantages of the disclosure will be apparent from the description and drawings, and from the claims.

### BRIEF DESCRIPTION OF DRAWINGS

FIG. 1A is a block diagram illustrating an example system configured to monitor and analyze power consumption signals over time for household equipment.
FIG. 1B is a block diagram illustrating an example detailed implementation of a system configured to monitor and analyze power consumption signals over time for household equipment.
FIG. 2A is a block diagram illustrating an example power cord device configured to monitor and analyze power consumption signals over time for household equipment.
FIG. 2B is a conceptual diagram illustrating an example power cord device that may be inserted between line power and household equipment to monitor and analyze power consumption signals over time.
FIG. 3 is a timing graph illustrating an example representative operating signature that includes characteristic points.
FIG. 4A illustrates an example of typography glyph metrics for an example typographical character.
FIG. 4B. is a time graph illustrating an example of applying glyph metrics to a representative operating signature according to one or more techniques of this disclosure.
FIG. 5 is a conceptual diagram illustrating identifying, from the plurality of devices, a subset of devices that have similar device characteristics and operate with similar environmental conditions to a target mechanical device.
FIG. 6 is a flow chart illustrating an example operation of system configured to monitor and analyze power consumption signals over time for household equipment.
FIG. 7 is a flow chart illustrating an example operation of power cord device configured to monitor and analyze power consumption signals over time for household equipment.

### DETAILED DESCRIPTION

This disclosure describes a system that monitors and analyzes power consumption signals over time for household equipment. As explained in greater detail below, the power consumption signals may exhibit a representative operating signature for the household equipment and/or components of the household equipment. Examples of such equipment include heating, ventilation, and air conditioning (HVAC) equipment and other household equipment, such as refrigerators, washing machines, garage door openers, sump pumps, pool pumps, well pumps or other pumps, fans, and so on. Using analytics, the system monitors the performance of the household equipment, which may provide an early warning as to whether the equipment or some component of equipment is performing abnormally and may potentially fail. Failing household equipment can result in consequences that range from inconvenience to property damage, to personal danger.

The system may be configured to determine a 'normal' operating signature for a piece of monitored equipment, which may include minimum and maximum expected ranges for different transition points or other characteristic points in the signature. The characteristic points may include points of minimum variability in magnitude of measured current, measured power, measured vars, or some similar indication of the operating signature for the monitored equipment. In some examples, the system may operate in a learning mode to measure and analyze the operating signature to determine transition points. In other examples, the system may receive a "normal" operating signature, e.g., from an equipment manufacturer, a testing service, or similar source.

Based on monitoring the characteristic points, the system may make a binary determination of "normal" or "abnormal." In other words, the system may determine that an operational run of the equipment is good or "potentially not good," based on a comparison of the measured characteristics points to a normal operating signature.

Conventional performance monitoring may be so cost prohibitive that such monitoring may be limited to large facilities (e.g., power generation facilities, manufacturing facilities, production facilities, etc.), with equipment that is typically very large and critical to operating facilities that generate large amounts of products and money. Such large and/or critical equipment may be monitored by expensive sensors and monitoring systems. In addition, such systems may measure detailed performance tracking, e.g., digitizing every operational cycle of every monitored piece of equipment. Sampling the entire operational signature of equipment may generate terabytes and petabytes of data, which may quickly fill expensive data storage locations, such as in data centers, as well as consume internet bandwidth and processing power to perform the analysis. For example, detailed analysis of hundreds, or thousands, of collected data points for an operational signature to detect an anomaly in the data may consume considerable processing time. Such conventional performance monitoring may repeat this process for each operational cycle of many separate pieces of equipment, thus multiplying the needed data processing power and data storage space.

In contrast, the performance monitoring techniques of this disclosure may present a technical solution that improves the technology of performance monitoring by potentially limiting data transfers by 99.9% compared to conventional techniques, without losing efficacy. The system of this disclosure may provide household monitoring of equipment, such as refrigerator, garage door opener, sump pump, HVAC systems and so on at a fraction of the cost of conventional performance monitoring. In this manner, the system of this disclosure may bring the cost of performance monitoring to a low enough level to distribute performance monitoring to households, light industrial or office buildings.

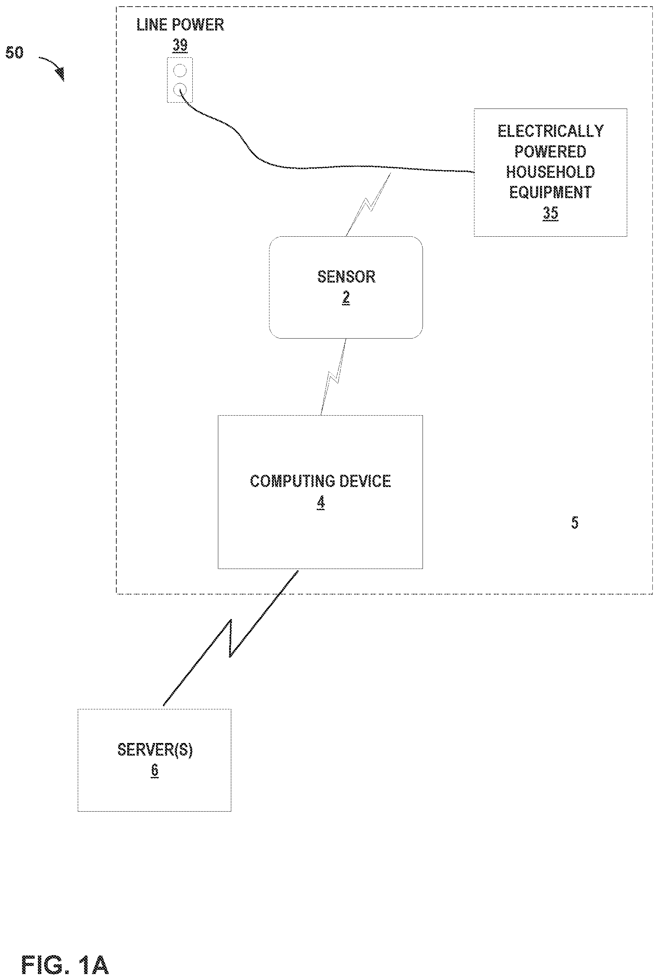

FIG. 1A is a block diagram illustrating an example system configured to monitor and analyze power consumption signals over time for household equipment. System 50 may include a power consumption monitoring device for small to medium sized equipment, such as equipment found in household 5, e.g., single family home, apartment and the like. Household 5 may also include office spaces, light industrial, workshops and so on that may include electrically powered equipment 35, e.g., HVAC systems, attic fan, window or split type air conditioners/heat pumps, water softeners, computer or lab equipment, fish tanks, and so on.

System 50 may include electrically powered equipment 35 (equipment 35 for short) connected to line power 39. Sensor 2 may monitor the electrical power consumed by equipment 35. In some examples sensor 2 may output a signal indicative of the electrical power consumed by equipment 35 to computing device 4. In some examples, processing circuitry of computing device 4 may determine, from the signal, an indication of an operating signature for equipment 35.

The operating signature may be different for different types of equipment. For example, an operating cycle of a garage door opener may include an initial surge of power as the motor starts, a period of time of power, followed by power dropping to zero. Operating cycles for a refrigerator may include a compression cycle, a defrost cycle, and so on, with different operating signatures for each. In addition, a defrost cycle for a first model or brand of refrigerator may differ from a second model and/or brand of refrigerator. In some examples, examining the representative operating signature may identify the type of equipment, and may also identify the model and/or brand of equipment. In this disclosure, an operational cycle may also be referred to as an operational run.

The operating signature may include a plurality of characteristic points. A respective characteristic point of the operating signature may be a sampled data point in which a magnitude of measured power by the sensor varies only a small amount, when compared to other data points of the operating signature. In some examples magnitude of measured power may vary within a threshold range of magnitude. In some examples a characteristic point may be a sampled data point that occurs within a threshold range of time in the operating signature. In some examples, a characteristic point of the operating signature may include a sampled data point that occurs at a transition point within the operating signature. Measurements of power may include measured current, measured power, measured vars, or some similar indication of the operating signature for the monitored equipment.

Processing circuitry of system 50 may compare respective characteristic points of the plurality of characteristic points to respective thresholds for each characteristic point stored at memory coupled to the processing circuitry (not shown in FIG. 1A.). In response to determining that one or more respective characteristic point in the operating signature is outside a respective threshold for the respective characteristic point, the processing circuitry of system 50 output an electronic message that includes an indication of abnormal behavior for equipment 35.

In some examples, sensor 2, may include processing circuitry and a memory configured to analyze operating signature and identify the characteristic points. In some examples, the processing circuitry of sensor 2 may also perform the comparisons of the characteristic points to the thresholds. In some examples, processing circuitry of sensor 2 may make a binary determination of "normal" or "abnormal," based on the comparison. For example, a characteristic point of a garage door opener that indicates the magnitude of power is higher than an expected threshold may indicate the garage door springs are out of adjustment. A characteristic point for a pump with a magnitude of power that is higher than a threshold may indicate a blockage, or worn bearings. The characteristic point for a pump with a magnitude of power that is lower than a threshold may be abnormal behavior that could indicate a leak, or some other malfunction.

In some examples, the processing circuitry of sensor 2 may perform the analysis and comparison. In other examples, sensor 2 may just collect the power signature data, and send a message to computing device 4 that may include the entire operating signature, some down-sampled version of the operating signature, just the characteristic points, or some other message with data that includes characteristics of the operating signature. The processing circuitry of computing device 4 may perform the analysis and comparison of the characteristic points to the threshold values.

In some examples, in response to each characteristic point in the operating signature satisfying each respective threshold for the respective characteristic point, computing device 4 may determine whether to output a message to servers 6. In other examples, sensor 2 may perform the comparison and determine whether to output a message to computing device 4. In either case, advantages of transmitting a message only when needed and refraining from transmitting a message if not needed may include reducing the volume of data that needs to be transmitted and stored, thereby reducing bandwidth congestion, power consumption used to transmit the messages, and reducing costs and reliability issues associated with transmitting large amounts of data.

A characteristic point may satisfy the respective threshold for that characteristic point when the magnitude of that characteristic point is within a threshold range, greater than a low or minimum threshold or less than a maximum or high threshold. A characteristic point may exceed a threshold by, for example, being outside of a threshold range, being less than a minimum or low threshold or being greater than a high or maximum threshold for that point. Similarly, a characteristic point that is based on timing may occur within a threshold time range or occur after a minimum time threshold or before a maximum time limit and therefore satisfy the threshold. Failure to satisfy a threshold may indicate possible abnormal behavior, and the processing circuitry transmit the message, e.g., from sensor 2 to computing device 4 and/or from computing device 4 to servers 6. The message may notify a user of the electrically powered equipment of the abnormal behavior.

In some examples, the processing circuitry of system 50 may transmit a message, even though each characteristic point in the operating signature satisfies each respective threshold. For example, processing circuitry of system 50 may execute instructions that cause the processing circuitry to periodically output a message that the monitored equipment, e.g., equipment 35, is operating normally. In some examples, the processing circuitry may output a "system normal" message daily, weekly, hourly and so on, depending on the equipment. Such a message may confirm communication between sensor 2, computing device 4 and/or servers 6. When equipment 35 is a security system, a more frequent 'system normal' message may be useful, whereas for a washing machine, a weekly message may be sufficient. In other examples, the period may be based on a number of operating cycles for the equipment. For example, a furnace may output a 'system normal' message after every tenth, or any other number, of heating cycles. In other words, to determine whether to output a message may include the processing circuitry of system 60 to check whether an interval has expired. In response to the interval expiring, output a "status normal" type message, e.g., to servers 6. In response to the determination that no message is warranted, refrain from transmitting the message.

The above description may be considered an operational mode for system 50, in which processing circuitry of system 50 may make binary decisions based on characteristic points in an operating signature to minimize bandwidth use and data storage. In some examples, system 50 may be configured to operate in a learning mode for a first period of time and after the learning mode, operate in the operational mode for a second period of time, or duration. The learning mode may be useful on a new install, or after a repair or replacement of equipment 35 or of one or more components of equipment 35. For example, replacing a circulation blower for an HVAC system may result in a different representative operating signature for the HVAC system because the replacement circulation blower may be of a different type and have different power characteristics than the original circulation blower.

In the learning mode, the processing circuitry of system 50 may be configured to analyze the received indication of the operating signature for the electrically powered equipment 35. The processing circuitry, e.g., for sensor 2 and/or computing device 4, may output the message, which includes the operating signature, to servers 6. The message may include a detailed operating signature with a large number of data points, initially, which computing device 4 and/or servers 6 may use to identify equipment 35. While in the learning mode and after the processing circuitry outputs the message comprising the operating signature, the processing circuitry for system 50 receive an identification of the electrically powered equipment 35, e.g., from servers 6. Also, while in the learning mode and after the processing circuitry outputs the message comprising the operating signature, the processing circuitry for system 50 may receive the respective thresholds for each characteristic point. System 50 may exit the learning mode, or be commanded by a user to exit the learning mode, and then function in the operational mode described above.

In some examples, system 50 may further reduce data transmission, storage and analysis burden by using a neighbor comparison of equipment similar to equipment 35, but located in a different household than household 5. In some examples, processing circuitry of system 50, e.g., servers 6, identify, from the plurality of electrically power equipment, a subset of equipment with similar device characteristics and similar environmental conditions to equipment 35. For example, servers 6 may store a database including data for a plurality of electrically powered mechanical devices, i.e., electrically powered equipment. Servers 6 may compare device characteristics, including one or more of: a type of device, a manufacturer, a model, a geographical location, a flow rate, a normal operating electrical current draw, and an operating temperature, or other characteristics.

A similar device operating in similar environmental conditions, which is referred to as a neighbor device in this disclosure, may have a similar representative operating signature to equipment 35. Processing circuitry of server 32 may execute instructions that consider operations of a neighbor device as one input factor to provide the representative operating signature, which includes threshold limits, to computing device 4 and/or sensor 2. In other words, processing circuitry of server 32, or other processing circuitry of system 50, may determine expected operating parameters for equipment 35 based on the operating parameters of the subset of similar devices in similar conditions (neighbor devices). Some examples of equipment characteristics may include one or more of: a type of device/equipment, a manufacturer, a model, a geographical location, a flow rate, a normal operating electrical current draw, an expected operating temperature, a recommended operating temperature range, power rating, capacity, and so on. Examples of environmental conditions may include environmental conditions germane to the geographical location such as one or more of a climate type, a terrain type, a water table level, outside air temperature, outside humidity, weather conditions, prevailing wind direct and velocity, micro-climate information, and so on.

Within household 5, computing device 4, or processing circuitry of sensor 2, may determine whether equipment 35 is functioning outside the expected operating parameters. Computing device 4, or processing circuitry of sensor 2, may execute instructions to make a binary decision of whether equipment 35 is functioning normally, e.g., as expected within parameter thresholds, or abnormally and may require attention. Computing device 4, or processing circuitry of sensor 2, may determine whether to output a message, or in response to determining that no message is warranted, refrain from outputting the message.

In this manner, system 50 may monitor performance of equipment 35 in a manner that may use less computing resources, less network bandwidth, and less memory storage when compared to other techniques. Rather than individually analyzing the large amounts of sensor data from many separate monitored devices, system 50 may determine whether a device, of a plurality of devices, is operating abnormally when compared to other neighbor devices. System 50 may therefore consume computing resources to just analyze the one device that appear to be "functioning outside expected parameters" compared to neighbor devices, e.g., other similar devices operating under similar conditions. In this manner the techniques defined by Applicant's claim 1 may reduce network bandwidth for transmitting large amounts of data, and reduce memory and computing resources for the detailed analysis of many devices to just a detailed analysis of the device "functioning outside expected parameters."

In some examples, system 50 may operate using techniques to determine whether many thousands of devices, spread across a large region, in many separate households could be considered "neighbor devices." The improvements to performance monitoring of system 50, e.g., reduced memory storage, reduced computing power, reduced bandwidth use and so on, have specific utility that may provide a well-defined and particular benefit to the public.

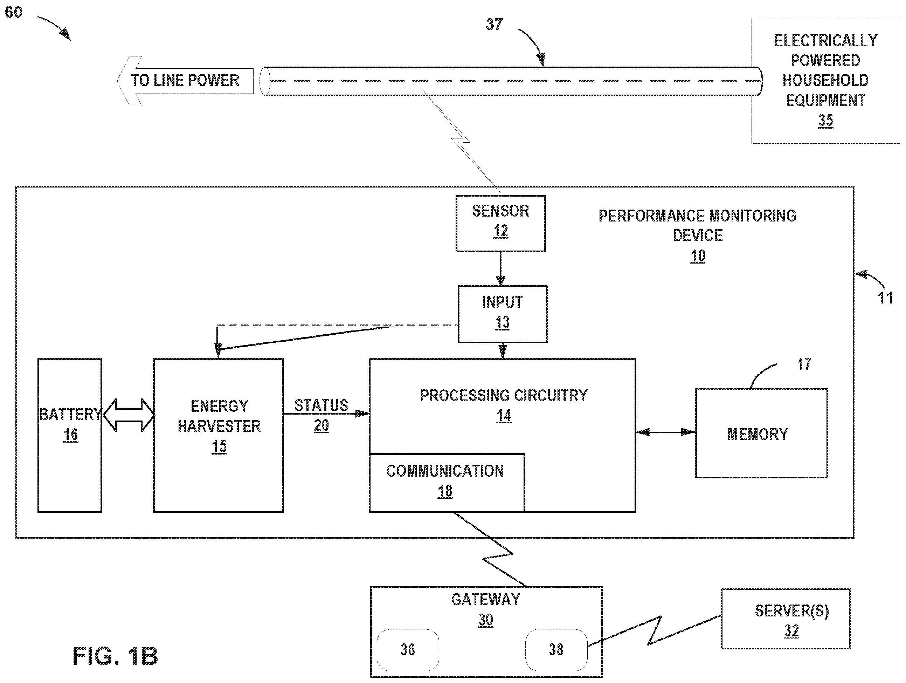

FIG. 1B is a block diagram illustrating an example detailed implementation of a system configured to monitor and analyze power consumption signals over time for household equipment. The example of FIG. 1 illustrates system 60 including the components of performance monitoring device 10 (device 10 for short). Device 10 may be attached to or otherwise coupled to a wire, for example, power cord 37, a power wire, or the like, of electrically powered household equipment 35 (equipment 35 for short). For example, device 10 may be a part of a clamping mechanism that is clamped around power cord 37 of equipment 35. As another example, device 10 may be integrated into power cord 37 of equipment 35, or as a connection interface between the power plug of the equipment and the power socket connected to line power of a building. Equipment 35 of FIG. 1B corresponds to equipment 35 of FIG. 1A and has the same functions and characteristics.

The example of FIG. 1B will focus on monitoring performance by measuring power consumption of equipment such as by monitoring electrical current drawn by the equipment. In other examples, the power monitoring device of this disclosure may monitor any power characteristics, including any of the power (watts), voltage-amperes reactive (vars) or electrical current (amperage) over time. In this disclosure power consumption monitoring device 10 may also be described as power monitoring device 10, monitoring device 10, or performance tracking device 10. In some examples, device 10 may be considered an IoT device or IoT performance monitoring device, where IoT is internet of things.

System 60 may also include gateway 30 connected to server 32. Gateway device 30 is a computing device including one or more processors 36, memory, communication circuitry 38 and so on. Gateway device 30 may communicate with device 10, as well as several other similar current monitoring devices connected to other household equipment in a building, such as refrigerator, washing machine, garage door opener, sump pump, pool pump, well pump or other pumps, fans and so on. As with servers 6, described above in relation to FIG. 1, servers 32 may include on-site or off-site computing devices, such as a cloud computing service.

In some examples, performance monitoring device 10, in the example of FIG. 1B may correspond to sensor 2 described above in relation to FIG. 1A. Gateway 30 may correspond to computing device 4 and servers 6 in FIG. 1B may correspond to servers 32 in FIG. 1A. As described above in relation to FIG. 1A, in some examples, performance monitoring device 10 may simply communicate any measured operating signature for equipment 35 to gateway 30 and processing circuitry 36 of gateway 30 may perform the comparisons to determine whether any characteristic points are within expected thresholds. In other examples, processing circuitry 14 of performance monitoring device 10 may perform the analysis and comparisons of the characteristic points to the thresholds.

Device 10 may include a housing, which encloses input component 13 (input 13), processor 14 (processing circuitry 14), memory 17, communication circuitry 18, energy harvester 15, energy storage unit 16 (battery 16) and in some examples encloses sensing mechanism 12 (sensor 12). In example, the components of the power monitoring device may be integrated into the power plug and the current sensing mechanism may run through the power cord. For example, in the example in which the current sensing mechanism (sensor 12) is a current transformer, then the current transformer (CT) includes a metal component. In an example where the current transformer is integrated into a power cord or cable, the metal component may be drawn into a thin wire that runs the length or a substantial length of the power cord or cable. This arrangement may allow device 10 to be integrated into standard power cables without significantly increasing the size of the power cord or cable. In other example, device 10 may be integrated into a circuit breaker or fuse with all the components of device 10 integrated into the circuit breaker or fuse. Thus, as the equipment draws power from the main power source, device 10 can identify a current signal as the power is drawn through the circuit breaker. The circuit breaker or fuse may also be integrated into the equipment itself. Similarly, device 10 itself may be integrated into the equipment, for example, not as part of a circuit breaker or fuse.

Device 10 may include sensor 12, configured as the current sensing mechanism, such as a current transformer. However, sensor 12 may also be configured to sense other power characteristics, e.g., vars, as described above. Some examples of sensor 12 may be a current transformer, current transducer, Hall effect sensor, resistor, coil, or any other type of current sensing component. Sensor 12 may also be referred to as current sensing mechanism 12. Sensor 12 may be any type of component or mechanism that can sense or detect electric current traveling through a wire or detect other power consumption signals, e.g., vars, watts and so on. Sensor 12 then generates a signal that is proportional to or that corresponds to the current. Thus, sensor 12 may be a component that directly senses current or may be a component that senses another electrical characteristic (e.g., voltage, resistance, etc.) and that can convert the detected electrical characteristic to a current measurement or power measurement. In other words, sensor 12 may directly measure power, or measure some other characteristic, electrical current, from which the processing circuitry of FIG. 1B may derive power. For example, by measuring changes in electrical current, such as with a Hall sensor, current transformer and so on, and knowing, or measuring, the operating voltage of equipment 35, device 10 may derive the power operating signature according to the equation P = IV, where power equals the voltage multiplied by the current.

In the example of FIG. 1, sensor 12 is illustrated as being contained within the housing 11. In other examples sensor 12 may be separate from housing 11. For example, sensor 12 may be attached to a power cord of the equipment and connected to housing 11 via input component 13. In some examples, sensor 12 may include a plug (not shown in FIG. 1) and housing 11 may include receptacles, e.g., input component 13 for accepting the plug. In other words, the device 10 may include a plug-and-play interface, e.g., input component 13, that receives one or more plugs from one or more sensors 12. The plug-and-play interface may also be configured to detect the amperage range for sensor 12. In some examples, housing 11 may be a waterproof and weatherproof housing suitable for use with outdoor equipment, such as a heat pump, air conditioning unit, circuit breaker, attic fan, pumps at water supply facilities, and other equipment located outdoors. In some examples device 10 may connect to a security system, or components of a security system, to monitor operation and ensure that the security system is operating. In some examples, device 10 may be configured to monitor the operation of an automated teller machine (ATM) or similar equipment to ensure the equipment is working as expected.

Device 10 may include multiple receptacles that could accept plugs from multiple sensors or other sensors. For example, device 10 could receive plugs from more than one sensor, thereby allowing a user to have a device 10 that can monitor multiple equipment via the use of multiple sensors 12. Alternatively, other sensors, for example, environmental sensors, microphones, and so on may be plugged into device 10 (not shown in FIG. 1). These additional sensors may provide additional information that can be used by device 10 to detect the state of health of equipment 35 monitored by device 10.

Sensor 12 may output a signal is output that corresponds to the current running through the wire. In other words, sensor 12 may measure electrical power consumed by electrically powered equipment 35 and output a signal indicative of the electrical power consumed by the electrically powered equipment 35, e.g., a signal indicating a magnitude of electrical current. Processing circuitry 14 may determine, from the signal, an indication of an operating signature for the electrically powered equipment, and the operating signature may comprise a plurality of characteristic points.

In some examples, this signal may run through input component 13, (also referred to as receptacles 13 in this disclosure) that allows for part of the signal to be directed to an energy harvester 15. In other examples, device 10 may omit receptacles 13 and sensor 12 may connect directly to processing circuitry 14 and other components of device 10. In the case that housing 11 and sensor 12 are included in the same housing, receptacles 13 may be a separate component or may be integrated into the energy harvesting hardware mechanism of energy harvester 15. The energy harvester 15 is electrically coupled to sensor 12, for example, through the receptacles 13. As a signal is output by sensor 12, or by capturing some of the signal input to the sensor 12, part of the signal may be directed to the energy harvester 15. In other words, in some examples, energy harvester 15 draws power from a signal associated with the current sensing circuitry. In the example in which the current sensing circuitry is a current transformer, the signal may be a current generated by the current transformer. In the example of other current sensing circuitry, the energy harvester may be coupled to the signal associated with the current sensing circuitry.

Thus, energy harvester 15 is energy harvesting circuitry configured to draw power from at least one electrical conductor of power cord 37. In some examples, energy harvester 15 may be configured to draw power from the signal associated with the current sensing circuitry, e.g., sensor 12, as described above. In other examples, energy harvester 15 may connect between at least two electrical conductors, e.g., wires, of power cord 37 and draw power to operate device 10.

Energy harvester 15 may charge energy storage unit 16. Energy storage unit 16 may be a rechargeable battery or may be another type of component that can store energy. For example, energy storage unit 16 may be a super-capacitor that stores energy. Energy storage unit 16 may be used to provide power to the rest of device 10 circuitry. In some examples, energy storage unit 16 may include a lithium-ion battery for use in cold locations and a nickel-metal-hydride (NiMH) battery for use in hot locations. Energy storage unit 16 may also be referred to as energy storage device 16 in this disclosure.

Processing circuitry 14 receives the signal from sensor 12. Processing circuitry 14 can be any type of processor, microcontroller, or other type of processing circuitry. Examples of processing circuitry 14 may include any one or more of a microcontroller (MCU), e.g., a computer on a single integrated circuit containing a processor core, memory, and programmable input/output peripherals, a microprocessor (µP), e.g., a central processing unit (CPU) on a single integrated circuit (IC), a controller, a digital signal processor (DSP), an application specific integrated circuit (ASIC), a fieldprogrammable gate array (FPGA), a system on chip (SoC) or equivalent discrete or integrated logic circuitry. A processor may be integrated circuitry, i.e., integrated processing circuitry, and that the integrated processing circuitry may be realized as fixed hardware processing circuitry, programmable processing circuitry and/or a combination of both fixed and programmable processing circuitry. Accordingly, the terms "processing circuitry," "processor" or "controller," as used herein, may refer to any one or more of the foregoing structures or any other structure operable to perform techniques described herein.

Device 10 may also include a memory 17 for storing data. In FIG. 1B memory chip 17 may be implemented as an OTA (over-the-air) flash memory chip, in some examples. However, any type of memory chip or computer readable storage media may be utilized. Memory 17 may store firmware updates for processing circuitry 14, a subset of historical signals received from sensor 12, current firmware for processing circuitry 14, or the like. The firmware updates may be provided over-the-air so that device 10 never has to be plugged into another information handling device. Firmware, or software stored at memory 17 may include instructions that cause processing circuitry 14 to execute the functions described herein. Additionally, memory 17 may store some information related to the signals received from sensor 12. For example, if device 10 cannot wirelessly connect or loses the connection to the second computing device that the information is being sent to, memory 17 may store the signal information until a connection can be made.

In some examples, processing circuitry 14 may read the signal from sensor 12, e.g., via an analog to digital converter, ADC, not shown in FIG. 1. As described above in relation to FIG. 1A, in some examples, processing circuitry 14 may also analyze and process the signal to identify characteristics of the equipment based upon the power consumption signal from sensor 12. In other examples, device 10 may transmit the entire sensed operating signature of equipment 35, for each operating cycle, to gateway 30. In other examples, processing circuitry 14 may perform some analysis of the operating signature, for example, identify characteristic points of the operating signature, and transmit via communication circuitry 18 a reduced data set of the characteristic points to gateway 30 for more detailed analysis. In other words, device 10 and gateway 30 may process and analyze the power consumption signal or different portions of the signal. By transmitting a data set of just the characteristic points may result in less data transmitted to gateway 30 when compared to transmitting the entire operating signature.

The characteristics may be used to determine if the equipment is performing as expected. If there is a deviation from the expected characteristics of the equipment, the system may determine that the equipment is experiencing an abnormal operating condition. Using analytics, the system may determine what the abnormal operating condition is, for example, whether the equipment or some component is failing. In some examples processing circuitry 14 may correlate the characteristics of the received power consumption signal to signals from other sensors, e.g., a temperature sensor indicating that the equipment experiencing changes environmental conditions, a microphone indicating an unusual noise frequency or noise level, or the like. In some examples, a microphone may detect sediment buildup in a tank, such as a water tank, well pressure tank, water softener and so on.

The power consumption signal from sensor 12, in some examples, may be a signal identifying characteristics of electrical current traveling through a first electrical conductor of the plurality of electrical conductors carrying current to equipment 35. Processing circuitry 14, may be configured to receive the signal from the sensor 12, and determine the characteristics of the electrical current based on the signal from sensor 12. Some example characteristics of the electrical current may include a magnitude, frequency, variability, a maximum and minimum magnitude over a specified duration, an associated voltage, noise carried in the current, and so on

In some examples, processing circuitry 14 may provide an alert or other notification to a user of the abnormal condition. In other examples, processing circuitry 36 of gateway 30 may output the signal that notifies the user of the electrically powered equipment of the abnormal behavior. The notification may be implemented in any way to alert a user that the equipment may need attention. Some examples may include, the signal may be received by a computing device, e.g., a mobile tablet, or similar computing device, be processed and displayed on a user interface. Other examples may include an indicator light, e.g., an LED to blink, or causes an audible alarm to sound.

As described above in relation to FIG. 1A, system 60 may function in an operational mode at some times and in a learning mode at other times. In the operational mode processing circuitry 14, or in some examples, processing circuitry 36, may make binary decisions based on characteristic points in an operating signature of equipment 35 to minimize bandwidth use and data storage. In other words, processing circuitry of system 60, in response to determining that a respective characteristic point in the operating signature of equipment 35 is outside a respective threshold for the respective characteristic point, may output an electronic message that includes an indication of abnormal behavior for equipment 35. In other examples, processing circuitry of system 60 may determine that no message is warranted, e.g., no characteristic points exceed a respective threshold, no interval has expired, and so on, and refrain from outputting a message. For example, processing circuitry 36 of gateway 30 may refrain from outputting the message to servers 32. In other examples, processing circuitry 36 may receive the indication of abnormal behavior and output a signal that notifies a user of the equipment 35 of the possible abnormal behavior of equipment 35.

As with system 50, described above, in some examples, system 60 may be configured to operate in a learning mode for a first duration and after the learning mode, operate in the operational mode for a second duration. In the learning mode, the processing circuitry of system 60, e.g., either or both of processing circuitry 14 or processing circuitry 36, may be configured to analyze the received indication of the operating signature for equipment 35. The indication of the operating signature may be received from current sensing circuitry, e.g., sensor 12, which may output a signal identifying characteristics of electrical current traveling through one or more electrical conductors of the plurality of electrical conductors of power cord 37.

While in learning mode, processing circuitry 36, for example, may output the message, which includes the operating signature, to servers 32. As described above in relation to FIG. 1A, the message may include a detailed operating signature with a large number of data points. In other examples, the message may include preliminary identification of possible characteristic points of the operating signature. While in the learning mode and after the processing circuitry outputs the message comprising the operating signature, the processing circuitry for system 60 receive an identification of the electrically powered equipment 35, e.g., from servers 6. Also, while in the learning mode and after the processing circuitry outputs the message comprising the operating signature, the processing circuitry for system 60 may receive the respective thresholds for each characteristic point. System 60 may exit the learning mode, or be commanded by a user to exit the learning mode, and then function in the operational mode described above.

In some examples, processing circuitry of system 60 may operate in learning mode for several operational cycles of equipment 35. In the example of a refrigerator, and HVAC system or other equipment, sensor 12 and processing circuitry 14 may collect two or more operational cycles, and output two or more messages, before processing circuitry of servers 32 identify equipment 35, and respond with a representative operating signature, e.g., including defined characteristic points, thresholds and so on.

In some examples, performance monitoring device 10 of this disclosure may receive data describing the representative operational cycle for equipment 35 in the form of a word comprising a set of characters, or runes, may need only limited processing power and limited memory 17 to analyze the performance of equipment 35. In some examples, processing circuitry 14 may decompose the language of the word that describes the equipment and may need to only sample and store a limited number of data points, e.g., characteristic points, and perform a comparison between the received runes and measured performance data (electrical current, power, etc.) to determine whether the equipment is operating as expected, or whether there are changes that may need to be reported and investigated further. The received representative operational signatures, in the form of runes may define thresholds, timing and so on for equipment 35. In some examples, the runes, describing the representative operational cycle for equipment 35, may be stored at servers 6, which may be an on-site or off-site computing device. The data describing the representative operational cycle for equipment 35 stored at servers 6 may be updated from time to time and sent to computing device 4 as needed.

In other words, the representative operational signature may be considered a 'normal' operating characteristic signature for a piece of monitored equipment, e.g., equipment 35. Servers 32 may transmit the representative operational signature to the local monitoring devices, e.g., power cord monitor, device 10 and/or gateway 30. The representative operating signature may, for example, include minimum and maximum expected ranges for different transition points or other characteristic points in the signature. Some examples of representative operating signatures may be a vector, with points along the X & Y axes (time and magnitude axes).

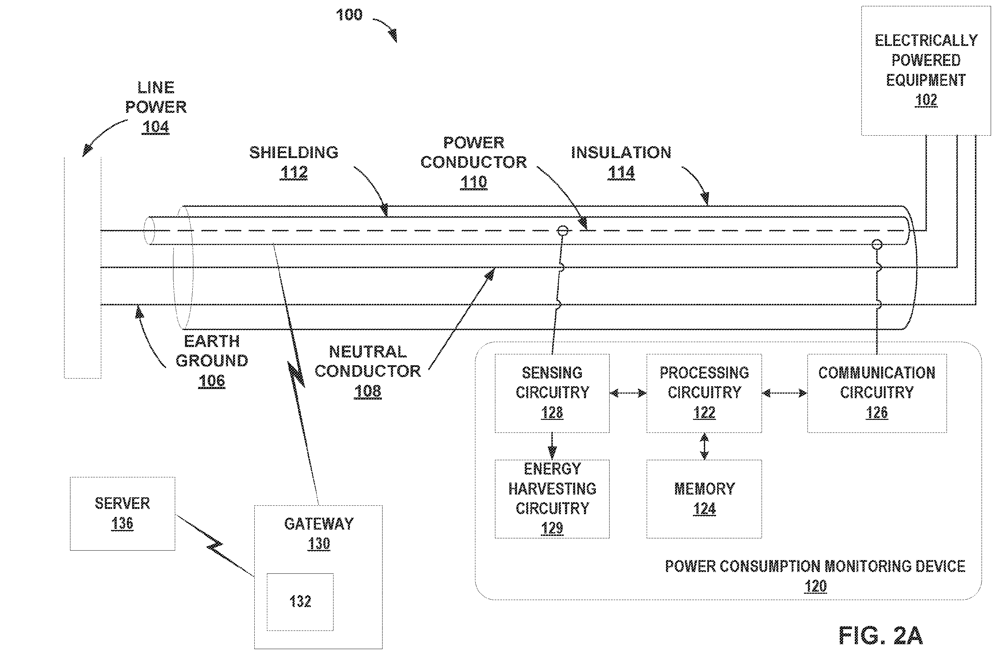

FIG. 2A is a block diagram illustrating an example power cord device configured to monitor and analyze power consumption signals over time for household equipment. System 100 is an example of systems 50 and 60, and components of FIG. 2A may have the same functions and characteristics as corresponding components described above in relation to FIGS. 1A and 1B. For example, server 136, gateway 130 with processing circuitry 132, power consumption monitoring device 120 with sensing circuitry 128, processing circuitry 122, communication circuitry 126, energy harvesting circuitry 129, and memory 124, and electrically powered equipment 102 may have the same functions and characteristics as respectively, servers 6 and servers 32, computing device 4, performance monitoring device 10 with sensor 12, processing circuitry 14, communication circuitry 18, energy harvester 15, and memory 17, as well as equipment 35. Some components may be present but not shown in FIG. 2A to simplify the description, such as battery 16. In other examples, system 100 may include more or fewer components than shown in the example of FIG. 2A.

The example of FIG. 2A shows a power cord device, similar to power cord 37 described above in relation to FIG. 1B, that connects equipment 102 to line power 104. The circuitry of power consumption monitoring device 120 (device 120 for short) may be included with the electrical conductors configured to carry alternating current (AC) power of the power cord device and form a device configured to monitor the performance of equipment 102. In some examples, sensing circuitry 128, processing circuitry 122 and so on may be implemented on a flexible and conformable circuit board and located within insulation 114. In other examples, the circuitry of device 120 may be located within a housing of the power cord device, with the electrical conductors passing through or near the housing.

In other examples, the components of system 100 may be implemented as a wall outlet, or a "smart plug" that plugs into line power at a wall outlet. Shielding/antenna 112 may be contained inside the housing of the wall outlet or plug device, or attached outside the housing.

In the example of FIG. 2A, the power cord device includes an electrical conductor, e.g., a wire, for earth ground 106, neutral conductor 108, and a wire for power conductor 110. Power conductor 110 may also be referred to as the "hot," "live," "line," or "phase" wire. In some examples, neutral conductor 108 may carry the return current from equipment 102 to line power 104. In other examples, the power cord device of system 100 may include more or fewer electrical conductors (wires), such as for three-phase power, high voltage equipment, and electrical systems in different regions of the world may have different arrangements of electrical conductors for the power cord device.

The power cord device in the example of system 100 includes shielding 112, which is an electromagnetic shield, configured to isolate the current sensing circuitry, e.g., sensing circuitry 128, from sensing a second electrical current traveling through a second electrical conductor, e.g., neutral conductor 108 of the plurality of electrical conductors in the power cord device. In some examples, electromagnetic shielding 112 is configured to act as an antenna for communication circuitry 126. Processing circuitry 122 may cause communication circuitry 126 to transmit and receive messages with gateway 130, as described above in relation to FIGS. 1A and 2A, via shielding 112.

Energy harvesting circuitry 129, as with energy harvester 15 described above in relation to FIG. 1B, may be coupled to at least one electrical conductor of the plurality of electrical conductors and configured to draw power from the at least one electrical conductor. In some examples, energy harvesting circuitry 129 may be configured to draw power from a signal associated with the current sensing circuitry 128. For example, sensing circuitry 128 may inductively couple to the AC power traveling through power conductor 110, e.g., using a current transformer. Energy harvesting circuitry 129 may use the signal received by sensing circuitry 128 to device 120. In other examples, energy harvesting circuitry 129 may be electrically connected between two conductors of the plurality of conductors in the power cord device. For example, energy harvesting circuitry 129 may be electrically connected between power conductor 110 and neutral conductor 108, such as through a high impedance resistor, or some equivalent means. In this manner, energy harvesting circuitry 129 may draw power from the electrical conductors for the circuitry of power consumption monitoring device 120.

As with systems 1A and 1B described above, the power cord device of system 100 is configured to be coupled between a power supply and electrically powered equipment. In some examples, processing circuitry 122 may receive a representative operating signature of equipment 102, e.g., in the form of a rune or glyph, which may include thresholds for characteristic points in the operating signature. Processing circuitry 122 may store the representative operating signature at memory 124 and compare characteristic points to the stored thresholds. Processing circuitry 122 may execute instructions, e.g., also stored at memory 124, to make a binary decision between normal and possibly abnormal behavior, based on the comparisons. Processing circuitry 122 may determine whether to output a message to gateway 130, e.g., based on the comparisons, based on the expiration of an interval, or other factors. In response to the determination, processing circuitry 122 may refrain from causing communication circuitry 126 to output the message to gateway 130.

In other examples, processing circuitry 132 of gateway 130 may receive the representative operating signature of equipment 102. Processing circuitry 132 may execute instructions to make binary decision between normal and possibly abnormal behavior, based on the comparison of the measured operating signature received from device 120 via communication circuitry 126 and shielding 112, acting as an antenna. While in operational mode, the measured operating signature in the message from device 120 may be a detailed operating signature with many data points in some examples. In other examples, the message received by gateway 130 may be a reduced data set, and in some examples, may only include the characteristic points. In other words, the analysis and binary decision may be performed either by processing circuitry 122, by processing circuitry 132, or the analysis may be shared by both.

Gateway 130 may output a message to server 136, or refrain from outputting the message, based on the analysis. The message my include data indicating a state of health of equipment 102 based on the characteristics of the measured operating signature, e.g., measured electrical current. Some examples of characteristics of the operating signature may include: a current draw, a cycle time, real power, reactive power and current variability. In this manner, the local devices, e.g., gateway 130 and/or device 120, may make the binary determination and only upload detailed data to servers 136 if the data is "potentially not good," or when in learning mode. In this manner the detailed data, e.g., many samples per second, may stay local to the monitored equipment, e.g., equipment 102 without the need to continuously or regularly transfer and store large amounts of data.

In some examples, message may also notify a user of the electrically powered equipment of the abnormal behavior, or trigger another signal that notifies the user. For example, the message that includes an indication of possible abnormal behavior may cause an application running on a mobile computing device to notify a user of the abnormal behavior. In this disclosure, the user may be described as a homeowner, or other occupant of the household (e.g., dwelling, office, etc.) that includes equipment 102. In other examples, the user may also include a repair service contracted to service equipment 102. For example, equipment 102 may be a sump pump or an HVAC system for the household, e.g., household 5 described above in relation to FIG. 1A. The message of possible abnormal behavior to servers 136 may trigger a message to a repair service to look into the possible abnormal behavior. Other follow-on actions may include contacting the occupant of the household, dispatching a technician, sending a request to server 136 to collect a more detailed operating signature, and so on.

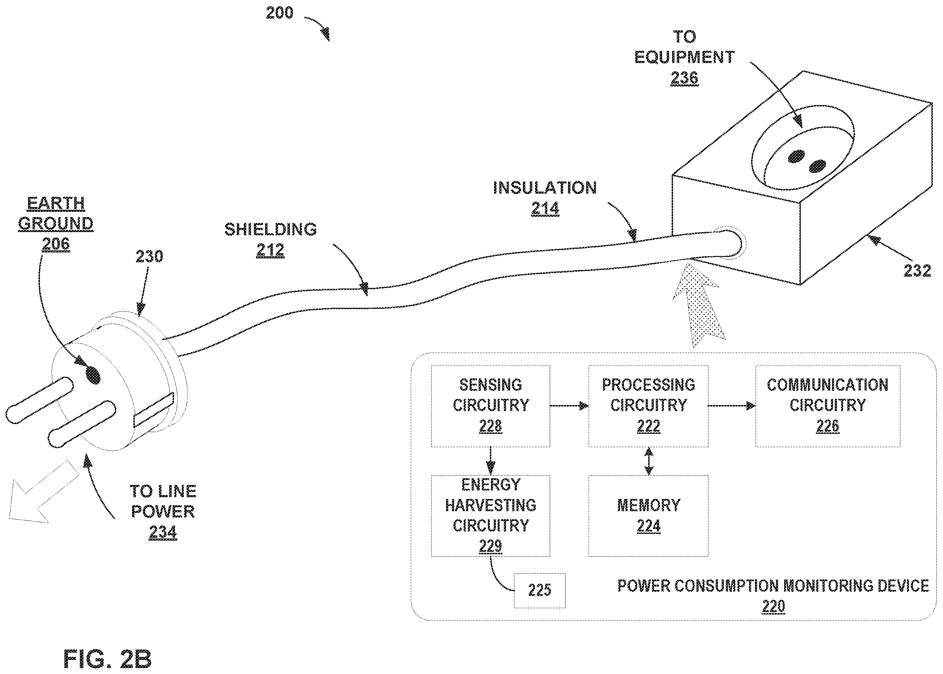

FIG. 2B is a conceptual diagram illustrating an example power cord device that may be inserted between line power and household equipment to monitor and analyze power consumption signals over time. Power cord device 200 is an example of systems 50, 60, and 100 described above in relation to FIGS. 1A - 2A. Components of FIG. 2A may have the same functions and characteristics as corresponding components described above in relation to FIGS. 1A - 2A. For example, power consumption monitoring device 220 with sensing circuitry 228, processing circuitry 222, communication circuitry 226, energy harvesting circuitry 229, energy storage device 226 and memory 124 may have the same functions and characteristics as respectively, performance monitoring device 10 with sensor 12, processing circuitry 14, communication circuitry 18, energy harvester 15, and memory 17 and battery 16. Some components may be present in a system including power cord device 200, but not shown in FIG. 2B to simplify the description, such as servers 136, gateway 130 and so on. In other examples, power cord device 200 may include more or fewer components than shown in the example of FIG. 2B.

As described above in relation to FIG. 2A, the circuitry of power consumption monitoring device 220 (device 220 for short) may be included with the electrical conductors may be implemented on a flexible and conformable circuit board and located within insulation 214. In other examples, the circuitry of device 220 may be located within housing 232 of the power cord device, with the electrical conductors passing through or near housing 232. Power cord device 200 may also include electromagnetic shielding 212 configured to isolate current sensing circuitry 228 from sensing a second electrical current traveling through a second electrical conductor of the plurality of electrical conductors of power cord device 200 different from the wire being measured by sensing circuitry 228. In some examples, a second current may cancel or interfere with the measurement of the power operating signature of the equipment.

In the example of FIG. 2B, power cord device 200 includes a plug 230 for connecting to line power 234 at a wall socket. Power cord device 200 also include a socket in housing 232 to connect to equipment 236. In this manner, power cord device 200 may connect between line power and any electrically powered equipment with a plug similar to plug 230. In some examples system 200 may be implemented as a multi-outlet extension cord that may service more than one piece of electrically powered equipment. Also, as described above in relation to FIG. 2A, the components of system 200 may be implemented as a wall outlet, or a "smart plug" that plugs into line power at a wall outlet. In other examples, e.g., as depicted in FIG. 2A, a power cord device of this disclosure may be directly wired to the monitored equipment, e.g., as a pigtail, without the need of a plug and/or socket. In some examples, power cord device 200 may provide advantages over other types of power monitoring devices such as low cost, ease of installation and configuration, and convenience to the user of electrically powered equipment. In some examples, power cord device 200 may be provided with the purchase of electrically powered equipment, or may be added later.

As described above in relation to FIGS. 1A - 2A, processing circuitry 222 may measure the operating signature of equipment connected to power cord device 200, e.g., by measuring current passing through an electrical conductor of power cord device 200. In some examples processing circuitry 222 may also analyzed the operating signature. In other examples, processing circuitry 222 may transmit the measured operating signature to another computing device, such as gateway 130 described above in relation to FIG. 2A. In other words, power cord device 200, or other components of the monitoring system of this disclosure, may identify parameters of the equipment by analyzing the characteristics the electrical current signal. The system may receive a representative operating signature, e.g., an expected power consumption signature, from an external computing device such as a server. The power monitoring system, including power cord device 200, may determine a state of health of the equipment based on comparing the analyzed current signal to the expected power consumption signature.

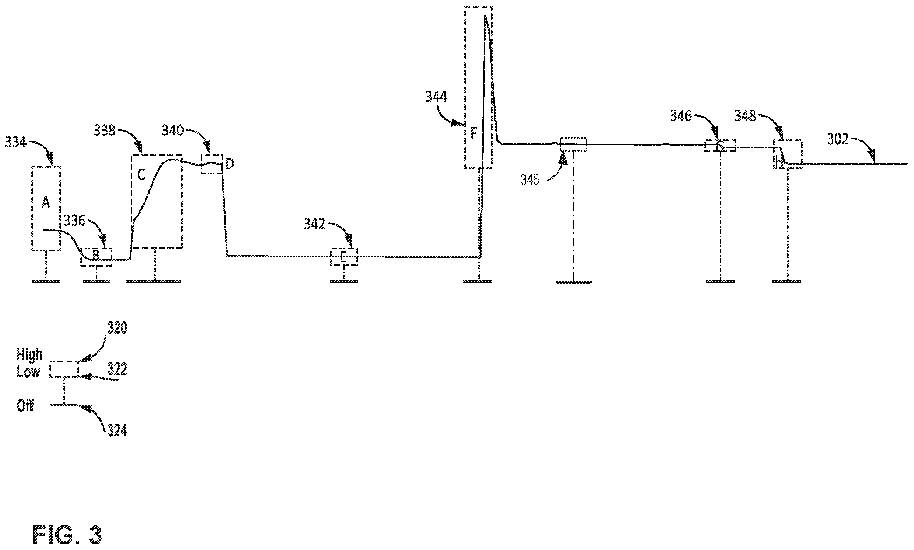

FIG. 3 is a timing graph illustrating an example representative operating signature that includes characteristic points. In some examples, characteristic point of the operating signature 302 may be a sampled data point in which a magnitude of measured power by the sensor, such as sensor 12 of FIG. 1B, varies within a threshold range. In other examples, a characteristic point may be a sampled data point that occurs within a threshold range of time in the operating signature. In other examples, a characteristic point of the operating signature comprises a sampled data point that occurs at a transition point within the operating signature.

The example of FIG. 3 illustrates the operating signature, as measured by a current draw, of a forced air furnace system. During a furnace operating cycle, a furnace may start an induction blower (334), which results in an initial surge of current, as with most electrical motor, which may settle to a steady state power level (336). Once the furnace controller confirms the induction blower is operating properly, the ignitor starts (338) and a gas valve may open (340) allowing flammable gas to flow into the combustion chamber. With a confirmed flame, the ignitor shuts off and the power consumption drops to a steady state (343) while the furnace heats. The furnace controller may cause the circulation blower to start, resulting in an initial surge of current (344), which drops to a steady state current (345). The operational cycle continues until the thermostat indicates the rooms have reached the desired temperature, and the controller closes the gas valve (346) and shuts off the induction blower (348). The circulation blower may continue to operate for a specified duration (shown at 302) to remove heat from the combustion chamber and circulate the removed heat through the duct system.

Some examples of a characteristic points in the operating signature of the furnace that varies very little, when compared to other events, may include B (336), D (340), E (342). In other words sampled data point in which a magnitude of measured power by the sensor, may vary within a small threshold range, when compared, for example to the variation of F (344), for example, a high threshold 320, low threshold 322 or off 324. An example of a transition point that may be used as a characteristic point may include G (346).

Processing circuitry of the performance monitoring system of this disclosure may compare characteristic points to a threshold, including a threshold range. For example, a characteristic point for the induction blower steady state (336) or the circulation blower steady state (345) that exceeds a threshold may indicate possible abnormal behavior. For example, if the circulation blower current is higher than expected, this may indicate worn bearings, which could cause the furnace to eventually fail to provide heat.

In other examples, the performance monitoring system may also determine whether the component timing is withing the expected start and end limits of the performance boundaries. The gas valve opening 340 should occur within a few seconds of the ignitor starting. In other examples, the timing of some characteristic points may vary based on, for example, environmental conditions. For example, the timing of the gas valve shut off (346) may take longer when the outside temperature is colder and may take less time when the outside temperature is not as cold. Comparing the timing threshold with a similar furnace operating in similar environmental conditions, e.g., a neighbor device, may provide useful information to determine whether the timing of the gas valve shutoff (348) could possibly be normal or abnormal.

In other examples, during ignition 338, the igniter may fail to light the flame and the furnace system may re-attempt ignition. The processing circuitry of the performance monitoring system may note the repeated ignition and flag the unexpected sequence as a possible issue. The processing circuitry may detect that multiple ignition attempts over several cycles may indicate an imminent component failure. Some example causes for repeated ignition attempts may include that the ignitor may not provide sufficient energy to ignite furnace, a pilot gas valve may be stuck, a gas valve may be stuck, the solenoid controlling the gas valve may have an issue and may require service, and so on. As described above in relation to FIGS. 1A - 2, the processing circuitry may execute instructions that result in a binary decision of normal operation or possible abnormal operation.

In some examples, while in learning mode, gateway 30 may receive messages from device 10, described above in relation to FIG. 1B, that is connected to the furnace. Processing circuitry of gateway 30 may execute an algorithm to create the 'word' or 'letters' based on the signal from device 10 connected to the equipment. In some examples, gateway 30 may compare the monitored power signals to the received data describing an operational cycle for the electrically powered equipment in the form of a word, by parsing the electrical signature into predetermined portions, or characteristic points. Gateway 30 may then compare the measured power signature to the 'letters' or 'words' and if the comparison shows the power signature is different from the expected, as defined by the received representative operating signature, gateway 30 may send information to server 32, e.g., connected to the cloud. In some examples, gateway 30 may not try to interpret the signal, but rather simply applies an algorithm and if different than the downloaded 'words/letters' gateway 30 sends the data to the cloud. In this manner, the monitoring process may reduce the complexity to a simple pattern match of characteristic points by gateway 30.

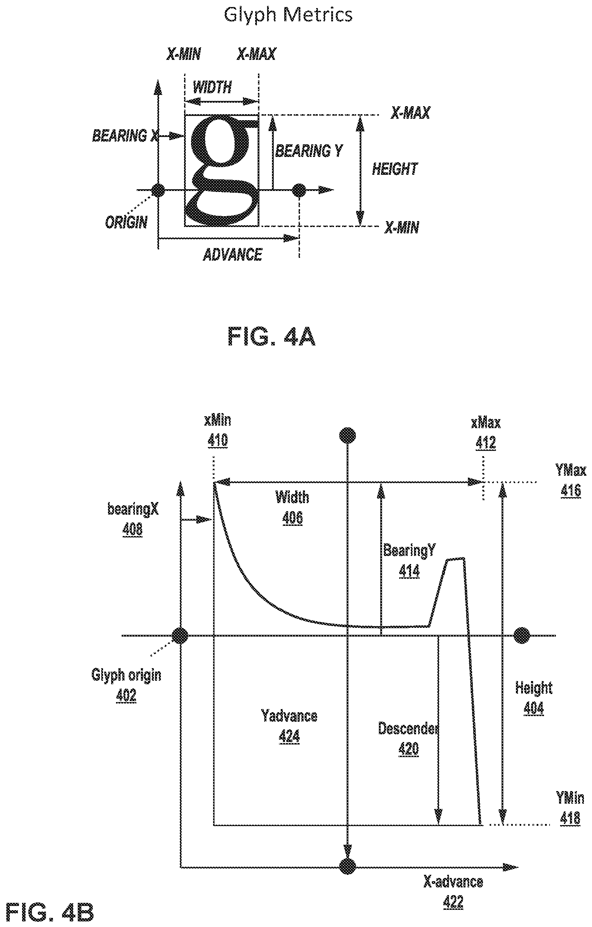

FIG. 4A illustrates an example of typography glyph metrics for an example typographical character. In the example of FIG. 10A, the character is a lower case English letter "g." The runes (also called glyphs) of this disclosure are based on typography and scale. Typography is a language to describe a character. For example, the English letter "C" can be identified as the letter C at small scale, e.g., a 4-point font, and at large scale, e.g., 400-point font and any scale in between. Typography also defines the how a letter combines with a previous letter and a following letter. In other words, for a given language, the transition between one letter and the next letter may be well defined. The letter C in a font library may look different between different fonts, but may still be identifiable as the letter C. Similarly, by looking at a letter C, a trained observer may be able to determine the font of that letter C.

Similarly, any piece of equipment has a sequence of events in which a component runs and transitions to the next component, or next operation of the same component. As described above in relation to FIGS. 1A -- 2, equipment, and/or a component of that equipment, may have a characteristic signature. For example, a component, such as a silicon nitrate (SiN) ignitor, of equipment, such as an HVAC system, may have a surging spike followed by a gradual drop, followed by a sharp drop as the ignitor shuts off. However, a first SiN ignitor may differ in the specific details of the characteristic signature, e.g., the maximum magnitude of the first spike, the timing between the start and shut off, the slope of the gradual drop, and so on. By observing the representative operating signature, a trained observer may determine the type of ignitor, e.g., SiN or some other type, the specific model of SiN ignitor, and whether the SiN ignitor is performing as expected.

The techniques of this disclosure, in some examples, may provide for an analysis of the characteristic signature for each component of equipment by describing the representative operating characteristic as a rune. The performance of the component may be analyzed at any scale. Different characteristics of a figure may be visible based on the scale. The scale may also be described as the zoom level. As one example, everything may appear flat at infinite scale.

As illustrated by the furnace run in FIG. 3, a rune may represent a transition point, which is when a component starts, stops, or start and runs for a programmed time duration. In some examples, induction is a sequence of an induction blower start and a predefined pre-purge window (334 and 336 of FIG. 3), ignition (338) is a start and a programmed time window before the gas valve runs. The gas valve starting (340) is a transition that includes the gas valve but also the igniter turning off. In some examples, a representative operating signature, in the form of a rune, may describe an entire operational cycle, e.g., the entire furnace run depicted by FIG. 3. In other examples, a representative operating signature may include a portion of an operational cycle. In other examples, such as a refrigerator that may perform different operational cycles, such as a cooling or compressor cycle and may also perform a defrost cycle, the performance monitoring system of this disclosure may store multiple representative operational signatures in memory for comparison.

In this manner, the performance monitoring device of this disclosure may receive a rune describing a representative operating signature, that includes performance bounds, e.g., duration, maximum and minimum expected current magnitude of characteristic points, and so on. With this rune, the performance monitoring device may have enough information to determine whether a component of the equipment is operating as expected and whether the performance has changed. As described above in relation to FIGS. 1A - 3, processing circuitry of the performance monitoring system may execute programming instructions to make a binary decision of whether the equipment, or a component of the equipment, is performing normally, as expected, or possibly needs attention. In other words, the performance monitoring system may determine whether an operational cycle of household equipment, e.g., a furnace run, geothermal heat pump operation, defrost cycle, garage door open/close cycle and so on, are performing as expected.

The techniques of this disclosure may reduce the complexity to simple pattern matching, such as comparing characteristic points to the stored representative operating signature. In this manner, the processing circuitry in the performance monitoring device, e.g., device 10 described above in relation to FIG. 1B, may be a low cost, basic processor configured to perform basic pattern matching analysis, communication tasks and so on. In this manner the performance monitoring device may be small, compact, lightweight and low cost allowing a user to purchase multiple performance monitoring devices for multiple pieces of household equipment. Similarly, gateway 30 may perform pattern matching and need not include an expensive processor requiring expensive heat dissipation and power consumption requirements. More complex analysis may be offloaded to a server, such as a workstation or laptop in the building, or an off-site server. In contrast to large, complex monitoring systems, such as at industrial facilities, the local monitoring devices of this disclosure may be less expensive, require less computing resources, less expensive storage capacity and consume less bandwidth, both on-site and communicating off-site. The system of this disclosure may differ from systems for large industrial sites with detailed performance tracking, e.g., digitizing every operational cycle of every monitored piece of equipment, which may generate terabytes and petabytes of data, and may quickly fill expensive data storage locations, such as in data centers, and consume internet bandwidth and processing power to perform the analysis. In this manner, the techniques of this disclosure reflect an improvement to the technology and technical field of real-time equipment performance monitoring and failure analysis. The elements of the performance monitoring system of this disclosure integrates the operation of processing circuitry into a practical application by bringing the cost and complexity of performance monitoring to a low enough level to be widely available to households, rather than limited to large, complex facilities. This disclosure does not seek to tie up and limit all forms of performance monitoring. Rather the techniques of this disclosure may apply to the meaningful limitations and specific techniques described above in relation to FIGS 1 - 4B.

FIG. 4B. is a time graph illustrating an example of applying glyph metrics to a representative operating signature according to one or more techniques of this disclosure. The example of FIG. 4B is an example of applying glyph metrics to a power signature for an ignitor according to one or more techniques of this disclosure. The representative operating signature for the ignitor in the example of FIG. 4B is similar to the ignitor signature (338) depicted in FIG. 3. The representative operating signatures differ because the type of ignitor is different for FIG. 4B when compared to FIG. 3.

The description of the rune (aka glyph) starts at the glyph origin 402. The rune starts at xMin 410 with bearingX 408 and bearingY 414 measured from glyph origin 402. Other descriptive elements may include width 406, Yadvance 424, Xadvance 422, xMax 412, Ymax 416, Ymin 418 and height 404. The rune of FIG. 4B also includes a descender 420. Other glyph elements for other representative operating signatures may also include features such as legs, joints and so on.

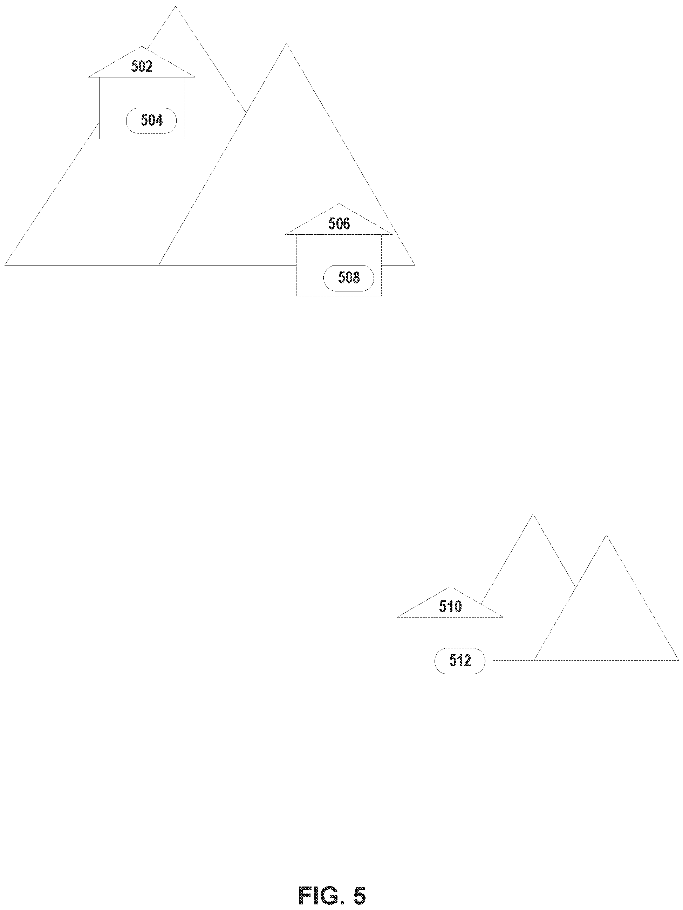

FIG. 5 is a conceptual diagram illustrating identifying, from the plurality of mechanical devices, a subset of mechanical devices that have similar device characteristics and operate with similar environmental conditions to a target mechanical device. In this disclosure, a similar mechanical device that operates under similar environmental conditions to a target mechanical device, may be referred to as a neighbor device to the target mechanical device.

Determining that a device is neighbor device does not necessarily mean that the device is geographically close to the target mechanical device. For example, a window air conditioning unit in a first geographical location may be considered a neighbor device of a target window air conditioning unit in a second geographical location, when the window air conditioning units are of a similar capacity, type, similar model, similar operating characteristics and so on. In some examples, the first geographical location may be within a few meters or within a few kilometers of the second geographical location, e.g., in the same town. In other examples the second geographical location may be in a different part of the world from the first geographical location. For example, parts of California may have similar environmental conditions to the region near Perth, Australia, as well as to certain areas near the Mediterranean Sea.

In the example of FIG. 5, household 502 may include a mechanical device 504, household 506 may include mechanical device 508 and household 510 may include mechanical device 512. Mechanical devices 504, 508 and 512 are examples of electrically powered equipment 35 and 102 described above in relation to FIGS. 1A - 2A and may have the same or similar functions and characteristics. Examples of mechanical devices 504, 508 and 512 may include HVAC systems, attic fans, pumps, window or split type air conditioners and heat pumps, water softeners, automatic teller machines, security monitoring systems, computer or lab equipment, fish tanks, and so on.

Computing devices of the performance monitoring system of this disclosure may store in a database, data for a plurality of mechanical devices. Each mechanical device of the plurality of mechanical devices in the database may be associated with one or more device characteristics, respective operating parameters, and respective environmental conditions. Some examples of device characteristics may include one or more of: a type of device (e.g., pump, HVAC system, garage door opener, etc.), a manufacturer, a model, a geographical location, a flow rate, a normal operating electrical current draw, an operating temperature, voltage rating, power supply type (e.g., single phase, three-phase) and so on. Respective operating parameters may include a mechanical parameter, such as: flow rate, valve position, pump rate, device temperature, pressure, outflow value. Operating parameters may also refer to an electrical parameter, e.g., electrical current draw, voltage magnitude, cycle time and so on.

Operating parameters may also include an operating environment parameter, which includes one or more of: water table level, sump pit water level, temperature, humidity, rainfall amount, and other weather conditions. The database may also store environmental conditions germane to the geographical location. Examples of environmental conditions may include a climate type, a terrain type, a water table level, outside air temperature, outside humidity, and weather conditions, air quality, UV index, solar insolation levels, and so on.

A computing device of the performance monitoring system, e.g., servers 32 and 136 described above in relation to FIGS. 1A - 2A, may store the database with data for the plurality of mechanical devices. Processing circuitry of the performance monitoring system may identify, from the plurality of devices, a subset of devices that have similar device characteristics and similar environmental conditions to a target mechanical device. For example, mechanical device 508 may be the target mechanical device, i.e., the mechanical device to be analyzed. Mechanical device 508 may be a similar device, e.g., a sump pump with a similar pumping capacity, an attic fan of the same model from the same manufacturer, or another device with similar operating characteristics. However, household 502 is located at a higher elevation, and therefore may be in a separate microclimate from household 506. Therefore the processing circuitry may determine that mechanical device 504 may not be used for comparison with mechanical device 508 because the devices do not operate under similar environmental conditions. However, household 510 may be in a different geographical location from household 506, but because both households are located in a valley of a mountainous region, in the example of FIG. 5, mechanical device 508 and mechanical device 512 may operate under similar environmental conditions. Therefore, mechanical device 512 may be in the subset of mechanical devices in the database that the processing circuitry may use for comparison.

In some examples, the processing circuitry may update the threshold limits for one or more characteristic points as the environmental conditions change. Updates to a representative operational signature may be based on changes in season, e.g., spring to summer, changes caused by large construction projects, e.g., highways, changes in sea level, and other factors.

The processing circuitry may determine expected operating parameters for the target mechanical device (508) based on the operating parameters of the subset of mechanical devices that may include mechanical device 512. In other words, as described above in relation to FIGS. 1A - 3, the processing circuitry may determine which representative operating signature best fits mechanical device 508 based, in part, on the operating for the subset of similar mechanical devices operating under similar environmental conditions.

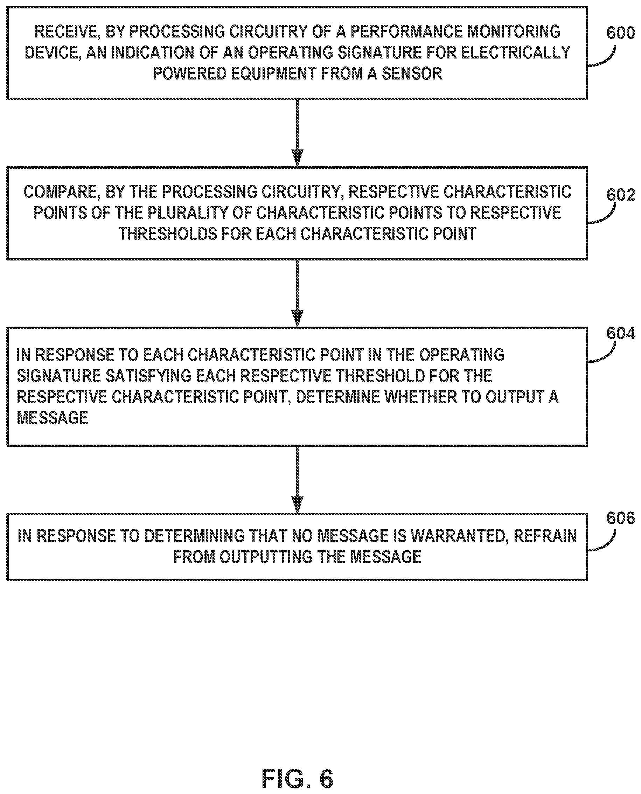

FIG. 6 is a flow chart illustrating an example operation of system configured to monitor and analyze power consumption signals over time for household equipment. The blocks of FIG. 6 will be described in terms of FIGS. 1A - 2B, unless otherwise noted.

As seen in the example of FIG. 6, processing circuitry 14 and/or processing circuitry 36 of the performance monitoring system 60, may receive an indication of an operating signature for electrically powered equipment from a sensor, e.g., sensor 12 (600). The indication may be a digitized form of measured current, vars, watts, and so on, as the electrically powered equipment 35 performs. In some examples, the indication may include sampled data points of various points along an operational cycle of the equipment, e.g., a garage door opener moving a garage door from open to closed, split heat pump performing a heating cycle in response to a room temperature being less than a thermostat set point, a defrost cycle of a HVAC heat pump, and so on. In some examples, the sampled data points may be limited to specific characteristic points of the operational cycle.

The processing circuitry may compare respective characteristic points of the plurality of characteristic points to respective thresholds for each characteristic point (602). As described above in relation to FIGS. 1 - 3, in some examples, processing circuitry 122 and 222 of a power cord device, such as power cord device 200 may receive the sensor data and perform the comparison. In other examples, processing circuitry 36 and processing circuitry 132 of the gateway may receive the sampled sensor data, and perform the comparison, track any interval timers, and make the binary decision of whether equipment 35, or equipment 102, is functioning within expected performance limits, e.g., performing normally. In other examples, the sensing, comparison and binary decision may be shared in any manner between the processing circuitry of the power cord device, and the processing circuitry of the gateway. For example, the power cord device may receive the indication of current from sensing circuitry 128, identify the characteristic points, and send a message to gateway 130 that includes just the characteristic points. Processing circuitry 132 of gateway 130 may perform the more complex comparison and timing tasks.

In other words, processing circuitry of the performance monitoring system may, in response to each characteristic point in the operating signature satisfying each respective threshold for the respective characteristic point, determine whether to output a message (604). Further, a processing circuitry may, in response to determining that no message is warranted, refrain from outputting the message (606).

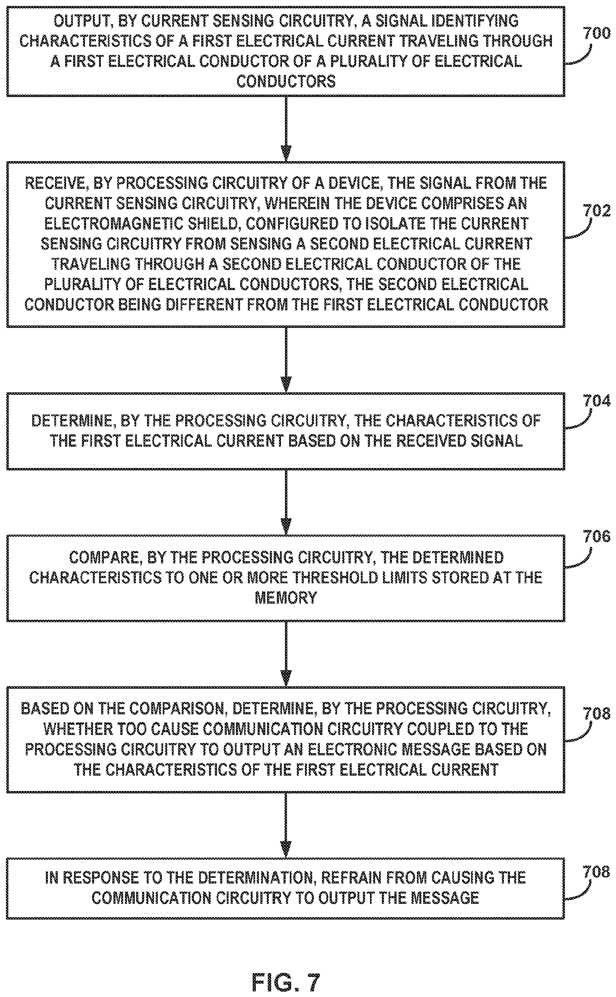

FIG. 7 is a flow chart illustrating an example operation of power cord device configured to monitor and analyze power consumption signals over time for household equipment. The power cord device of FIG. 7 corresponds to power cord device 200 described above in relation to FIG. 2B and the power cord device of system 100 described above in relation to FIG. 2A.

As seen in the example of FIG. 7, processing circuitry 122 initially may receive a signal that was output by current sensing circuitry 128 (700). The signal may identify one or more characteristics of a first electrical current traveling through a first electrical conductor of a plurality of electrical conductors.

Processing circuitry 122 may receive the signal from current sensing circuitry 128, which may be isolated by an electromagnetic shield (702). The shield may be configured to isolate the current sensing circuitry from sensing a second electrical current traveling through a second electrical conductor of the plurality of electrical conductors, the second electrical conductor being different from the first electrical conductor.

Processing circuitry 122 may determine characteristics of the first electrical current based on the received signal (704), e.g., current magnitude, frequency, etc. Processing circuitry 122 may compare the determined characteristics to one or more threshold limits stored at memory 124 (706). In other examples, processing circuitry 132 of gateway 130 may perform the comparison.

Processing circuitry 122, or 132, may, based on the comparison, determine whether to cause communication circuitry coupled to the processing circuitry to output an electronic message based on the characteristics of the first electrical current (708). In some examples, as described above in relation to FIGS. 1A - 6, the system processing circuitry may, in response to the determination, refrain from causing the communication circuitry to output the message (708).

In one or more examples, the functions described above may be implemented in hardware, software, firmware, or any combination thereof. For example, the various components of FIGS. 1A, 1B, 2A and 2B, such as servers 32, gateway 30, and processing circuitry 222 may be implemented in hardware, software, firmware, or any combination thereof. If implemented in software, the functions may be stored on or transmitted over, as one or more instructions or code, a computer-readable medium and executed by a hardware-based processing unit. Computer-readable media may include computer-readable storage media, which corresponds to a tangible medium such as data storage media, or communication media including any medium that facilitates transfer of a computer program from one place to another, e.g., according to a communication protocol. In this manner, computer-readable media generally may correspond to (1) tangible computer-readable storage media which is non-transitory or (2) a communication medium such as a signal or carrier wave. Data storage media may be any available media that can be accessed by one or more computers or one or more processors to retrieve instructions, code and/or data structures for implementation of the techniques described in this disclosure. A computer program product may include a computer-readable medium.

By way of example, and not limitation, such computer-readable storage media, may include random access memory (RAM), read only memory (ROM), programmable read only memory (PROM), erasable programmable read only memory (EPROM), electronically erasable programmable read only memory (EEPROM), flash memory, a hard disk, a compact disc ROM (CD-ROM), a floppy disk, a cassette, magnetic media, optical media, or other computer readable media. In some examples, an article of manufacture may include one or more computer-readable storage media. The term "non-transitory" may indicate that the storage medium is not embodied in a carrier wave or a propagated signal. In certain examples, a non-transitory storage medium may store data that can, over time, change (e.g., in RAM or cache).

Also, any connection is properly termed a computer-readable medium. For example, if instructions are transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. It should be understood, however, that computer-readable storage media and data storage media do not include connections, carrier waves, signals, or other transient media, but are instead directed to non-transient, tangible storage media. Combinations of the above should also be included within the scope of computer-readable media.

Instructions may be executed by one or more processors, such as one or more DSPs, general purpose microprocessors, ASICs, FPGAs, or other equivalent integrated or discrete logic circuitry. Accordingly, the term "processor," as used herein, such as processing circuitry 36, may refer to any of the foregoing structure or any other structure suitable for implementation of the techniques described herein. Also, the techniques could be fully implemented in one or more circuits or logic elements.

The techniques of this disclosure may be implemented in a wide variety of devices or apparatuses, including, an integrated circuit (IC) or a set of ICs (e.g., a chip set). Various components, modules, or units are described in this disclosure to emphasize functional aspects of devices configured to perform the disclosed techniques, but do not necessarily require realization by different hardware units. Rather, as described above, various units may be combined in a hardware unit or provided by a collection of interoperative hardware units, including one or more processors as described above, in conjunction with suitable software and/or firmware.

## Claims

1. A device (200), comprising:
a plurality of electrical conductors (110, 108) configured to carry alternating current (AC) power;
current sensing circuitry (128), wherein the current sensing circuitry (128) is configured to output a signal identifying characteristics of a first electrical current traveling through a first electrical conductor (110) of the plurality of electrical conductors (110, 108);
an electromagnetic shield (112), configured to isolate the current sensing circuitry (128) from sensing a second electrical current traveling through a second electrical conductor (108) of the plurality of electrical conductors (110, 108), the second electrical conductor (108) being different from the first electrical conductor (110);
communication circuitry (126) configured to communicate with an external computing device (136) separate from the device (200);
processing circuitry (122) operatively coupled to the current sensing circuitry (128) (128) and a memory (124), the processing circuitry (122) configured to:
receive the signal from the current sensing circuitry (128);
determine the characteristics of the first electrical current based on the signal;
determine whether to cause the communication circuitry (126) to output an electronic message based on the determined characteristics of the first electrical current;
compare the determined characteristics to one or more threshold limits stored at the memory (124);
based on the comparison, determine whether to output a message to the external computing device (136); and
in response to the determination of whether to output a message to the external computing device (136), refrain from causing the communication circuitry (126) to output the message.

2. The device (200) of claim 1, further comprising energy harvesting circuitry (129) coupled to at least one electrical conductor of the plurality of electrical conductors (110, 108), wherein the energy harvesting circuitry (129) is configured to draw power from the at least one electrical conductor;
and/or
wherein the device (200) is configured to be coupled between a power supply and electrically powered equipment, and
wherein the message comprises data indicating a state of health of the equipment based on the characteristics of the first electrical current;
and/or
wherein the electromagnetic shield (112) is configured to act as an antenna for the communication circuitry (126).

3. The device (200) of claim 2, wherein the energy harvesting circuitry (129) is configured to draw power from a signal associated with the current sensing circuitry (128).

4. The device (200) of claim 3, further comprising an energy storage device (226) electrically coupled to the energy harvesting circuitry (129), wherein energy harvested by the energy harvesting circuitry (129) charges the energy storage device (226).

5. The device (200) of claim 1,
wherein the device (200) is configured to be coupled between a power supply and electrically powered equipment, and
wherein the message comprises data indicating a state of health of the equipment based on the characteristics of the first electrical current, and
wherein one or more characteristics of the first electrical current comprise: a current draw, a cycle time, real power, reactive power and current variability.

6. The device (200) of claim 5, wherein the processing circuitry (122) is configured to:
identify parameters of the equipment by analyzing the determined characteristics of the first electrical current;
receive an expected power consumption signature from the external computing device (136); and
determine a state of health of the equipment based on comparing the analyzed determined characteristics of the first electrical current to the expected power consumption signature.

7. A system (100) comprising:
a gateway (130) comprising first processing circuitry coupled to a memory (124), the gateway (130) configured to communicate with a server (136);
a device (200), comprising:
a plurality of electrical conductors (110, 108) configured to carry alternating current (AC) power;
current sensing circuitry (128), wherein the current sensing circuitry (128) is configured to output a signal identifying characteristics of a first electrical current traveling through a first electrical conductor (110) of the plurality of electrical conductors (110, 108);
an electromagnetic shield (112), configured to isolate the current sensing circuitry (128) from sensing a second electrical current traveling through a second electrical conductor (108) of the plurality of electrical conductors (110, 108), the second electrical conductor (108) being different from the first electrical conductor (110);
communication circuitry (126) configured to communicate with the gateway (130);
second processing circuitry operatively coupled to the current sensing circuitry (128), the second processing circuitry configured to:
receive the signal from the current sensing circuitry (128);
determine the characteristics of the first electrical current based on the signal;
cause the communication circuitry (126) to output a message to the gateway (130), wherein the message includes the characteristics of the first electrical current;
the first processing circuitry of the gateway (130) is configured to:
receive the message with the characteristics of the first electrical current;
compare the determined characteristics to one or more threshold limits stored at the memory (124);
based on the comparison, determine whether to output a message to the server (136);
in response to the determination of whether to output a message to the server (136), refrain from outputting the message.

8. The system (100) of claim 7, the device further comprising energy harvesting circuitry (129) coupled to at least one electrical conductor of the plurality of electrical conductors (110, 108), wherein the energy harvesting circuitry (129) is configured to draw power from the at least one electrical conductor.

9. The system (100) of claim 8, wherein the energy harvesting circuitry (129) is configured to draw power from a signal associated with the current sensing circuitry (128);
and/or;
wherein the system (100) further comprises an energy storage device (226) electrically coupled to the energy harvesting circuitry (129), wherein energy harvested by the energy harvesting circuitry (129) charges the energy storage device (226).

10. The system (100) of claim 7, wherein the electromagnetic shield (112) is configured to act as an antenna for the communication circuitry (126).

11. The system (100) of claim 7,
wherein the device (200) is coupled between a power supply and electrically powered equipment, and
wherein the transmitted message comprises state of health of the equipment based on an analyzed characteristic of the first electrical current.

12. The system (100) of claim 11, wherein one or more characteristics of the first electrical current comprise: a current draw, a cycle time, real power, reactive power and current variability;
and/or
wherein the first processing circuitry is configured to:
identify parameters of the equipment by analyzing the determined characteristics of the first current signal;
receive an expected power consumption signature from the server (136); and
determine a state of health of the equipment based on comparing the analyzed determined characteristics of the first current signal to the expected power consumption signature.

13. A method comprising:
outputting (700), by current sensing circuitry (128), a signal identifying characteristics of a first electrical current traveling through a first electrical conductor (110) of a plurality of electrical conductors (110, 108);
receiving (702), by processing circuitry (122) of a device (200), the signal from the current sensing circuitry (128), wherein the device (200) comprises an electromagnetic shield (112), configured to isolate the current sensing circuitry (128) from sensing a second electrical current traveling through a second electrical conductor (108) of the plurality of electrical conductors (110, 108), the second electrical conductor (108) being different from the first electrical conductor (110);
determining (704), by the processing circuitry (122), the characteristics of the first electrical current based on the received signal;
comparing (706), by the processing circuitry (122), the determined characteristics to one or more threshold limits stored at the memory (124);
based on the comparison, determining (708), by the processing circuitry (122), whether to cause communication circuitry (126) coupled to the processing circuitry (122) to output an electronic message based on the characteristics of the first electrical current; and
in response to the determination of whether to output an electronic message based on the characteristics of the first electrical current (708), refraining from causing the communication circuitry (126) to output the message.

14. The method of claim 13, wherein the electromagnetic shield (112) is configured to act as an antenna for the communication circuitry (126);
and/or;
wherein the first electrical current powers electrically powered equipment, and
wherein the message comprises data indicating a state of health of the equipment based on the characteristics of the first electrical current.

15. The method of claim 13,
wherein the first electrical current powers electrically powered equipment, and wherein the message comprises data indicating a state of health of the equipment based on the characteristics of the first electrical current;
further comprising:
identifying parameters of the equipment by analyzing the determined characteristics the first electrical current;
receiving an expected power consumption signature from an external computing device (136); and
determining a state of health of the equipment based on comparing the analyzed determined characteristics of the first current signal to the expected power consumption signature.

## Patentansprüche

1. Eine Vorrichtung (200), die Folgendes beinhaltet:
eine Vielzahl von elektrischen Leitern (110, 108), die konfiguriert sind, um Wechselstrom (AC) zu führen;
eine Stromerfassungsschaltung (128), wobei die Stromerfassungsschaltung (128) konfiguriert ist, um ein Signal auszugeben, das Charakteristika eines ersten elektrischen Stroms identifiziert, der durch einen ersten elektrischen Leiter (110) der Vielzahl von elektrischen Leitern (110, 108) fließt;
eine elektromagnetische Abschirmung (112), die konfiguriert ist, um die Stromerfassungsschaltung (128) vom Erfassen eines zweiten elektrischen Stroms zu isolieren, der durch einen zweiten elektrischen Leiter (108) der Vielzahl von elektrischen Leitern (110, 108) fließt, wobei sich der zweite elektrische Leiter (108) vom ersten elektrischen Leiter (110) unterscheidet;
eine Kommunikationsschaltung (126), die konfiguriert ist, um mit einer externen Rechenvorrichtung (136) zu kommunizieren, die von der Vorrichtung (200) getrennt ist;
eine Verarbeitungsschaltung (122), die operativ mit der Stromerfassungsschaltung (128) (128) und einem Speicher (124) gekoppelt ist, wobei die Verarbeitungsschaltung (122) für Folgendes konfiguriert ist:
Empfangen des Signals von der Stromerfassungsschaltung (128);
Bestimmen der Charakteristika des ersten elektrischen Stroms basierend auf dem Signal;
Bestimmen, ob die Kommunikationsschaltung (126) veranlasst werden soll, eine elektronische Nachricht basierend auf den bestimmten Charakteristika des ersten elektrischen Stroms auszugeben;
Vergleichen der bestimmten Charakteristika mit einer oder mehreren Schwellengrenzen, die in dem Speicher (124) gespeichert sind;
basierend auf dem Vergleich, Bestimmen, ob eine Nachricht an die externe Rechenvorrichtung (136) ausgegeben werden soll; und
als Reaktion auf die Bestimmung, ob eine Nachricht an die externe Rechenvorrichtung (136) ausgegeben werden soll, Unterlassen des Veranlassens der Kommunikationsschaltung (126), die Nachricht auszugeben.

2. Vorrichtung (200) gemäß Anspruch 1, die ferner eine Energiegewinnungsschaltung (129) beinhaltet, die mit mindestens einem elektrischen Leiter der Vielzahl von elektrischen Leitern (110, 108) gekoppelt ist, wobei die Energiegewinnungsschaltung (129) konfiguriert ist, um Leistung von dem mindestens einen elektrischen Leiter zu beziehen;
und/oder
wobei die Vorrichtung (200) konfiguriert ist, um zwischen einer Leistungsversorgung und elektrisch betriebener Ausrüstung gekoppelt zu werden, und
wobei die Nachricht Daten beinhaltet, die einen Gesundheitszustand der Ausrüstung basierend auf den Charakteristika des ersten elektrischen Stroms angeben;
und/oder
wobei die elektromagnetische Abschirmung (112) konfiguriert ist, um als eine Antenne für die Kommunikationsschaltung (126) zu wirken.

3. Vorrichtung (200) gemäß Anspruch 2, wobei die Energiegewinnungsschaltung (129) konfiguriert ist, um Leistung von einem Signal zu beziehen, das mit der Stromerfassungsschaltung (128) assoziiert ist.

4. Vorrichtung (200) gemäß Anspruch 3, die ferner eine Energiespeichervorrichtung (226) beinhaltet, die elektrisch mit der Energiegewinnungsschaltung (129) gekoppelt ist, wobei durch die Energiegewinnungsschaltung (129) gewonnene Energie die Energiespeichervorrichtung (226) lädt.

5. Vorrichtung (200) gemäß Anspruch 1,
wobei die Vorrichtung (200) konfiguriert ist, um zwischen einer Leistungsversorgung und elektrisch betriebener Ausrüstung gekoppelt zu werden, und
wobei die Nachricht Daten beinhaltet, die einen Gesundheitszustand der Ausrüstung basierend auf den Charakteristika des ersten elektrischen Stroms angeben, und wobei eine oder mehrere Charakteristika des ersten elektrischen Stroms Folgendes beinhalten: eine Stromaufnahme, eine Zykluszeit, Wirkleistung, Blindleistung und Stromvariabilität.

6. Vorrichtung (200) gemäß Anspruch 5, wobei die Verarbeitungsschaltung (122) für Folgendes konfiguriert ist:
Identifizieren von Parametern der Ausrüstung durch Analysieren der bestimmten Charakteristika des ersten elektrischen Stroms;
Empfangen einer erwarteten Leistungsverbrauchssignatur von der externen Rechenvorrichtung (136); und
Bestimmen eines Gesundheitszustands der Ausrüstung basierend auf dem Vergleichen der analysierten bestimmten Charakteristika des ersten elektrischen Stroms mit der erwarteten Leistungsverbrauchssignatur.

7. Ein System (100), das Folgendes beinhaltet:
ein Gateway (130), das eine erste Verarbeitungsschaltung beinhaltet, die mit einem Speicher (124) gekoppelt ist, wobei das Gateway (130) konfiguriert ist, um mit einem Server (136) zu kommunizieren;
eine Vorrichtung (200), die Folgendes beinhaltet:
eine Vielzahl von elektrischen Leitern (110, 108), die konfiguriert sind, um Wechselstrom (AC) zu führen;
eine Stromerfassungsschaltung (128), wobei die Stromerfassungsschaltung (128) konfiguriert ist, um ein Signal auszugeben, das Charakteristika eines ersten elektrischen Stroms identifiziert, der durch einen ersten elektrischen Leiter (110) der Vielzahl von elektrischen Leitern (110, 108) fließt;
eine elektromagnetische Abschirmung (112), die konfiguriert ist, um die Stromerfassungsschaltung (128) vom Erfassen eines zweiten elektrischen Stroms zu isolieren, der durch einen zweiten elektrischen Leiter (108) der Vielzahl von elektrischen Leitern (110, 108) fließt, wobei sich der zweite elektrische Leiter (108) vom ersten elektrischen Leiter (110) unterscheidet;
eine Kommunikationsschaltung (126), die konfiguriert ist, um mit dem Gateway (130) zu kommunizieren;
eine zweite Verarbeitungsschaltung, die operativ mit der Stromerfassungsschaltung (128) gekoppelt ist, wobei die zweite Verarbeitungsschaltung für Folgendes konfiguriert ist:
Empfangen des Signals von der Stromerfassungsschaltung (128);
Bestimmen der Charakteristika des ersten elektrischen Stroms basierend auf dem Signal;
Veranlassen der Kommunikationsschaltung (126), eine Nachricht an das Gateway (130) auszugeben, wobei die Nachricht die Charakteristika des ersten elektrischen Stroms umfasst;
wobei die erste Verarbeitungsschaltung des Gateways (130) für Folgendes konfiguriert ist:
Empfangen der Nachricht mit den Charakteristika des ersten elektrischen Stroms; Vergleichen der bestimmten Charakteristika mit einer oder mehreren Schwellengrenzen, die in dem Speicher (124) gespeichert sind;
basierend auf dem Vergleich, Bestimmen, ob eine Nachricht an den Server (136) ausgegeben werden soll;
als Reaktion auf die Bestimmung, ob eine Nachricht an den Server (136) ausgegeben werden soll, Unterlassen des Ausgebens der Nachricht.

8. System (100) gemäß Anspruch 7, wobei die Vorrichtung ferner eine Energiegewinnungsschaltung (129) beinhaltet, die mit mindestens einem elektrischen Leiter der Vielzahl von elektrischen Leitern (110, 108) gekoppelt ist, wobei die Energiegewinnungsschaltung (129) konfiguriert ist, um Leistung von dem mindestens einen elektrischen Leiter zu beziehen.

9. System (100) gemäß Anspruch 8, wobei die Energiegewinnungsschaltung (129) konfiguriert ist, um Leistung von einem Signal zu beziehen, das mit der Stromerfassungsschaltung (128) assoziiert ist;
und/oder;
wobei das System (100) ferner eine Energiespeichervorrichtung (226) beinhaltet, die elektrisch mit der Energiegewinnungsschaltung (129) gekoppelt ist, wobei durch die Energiegewinnungsschaltung (129) gewonnene Energie die Energiespeichervorrichtung (226) lädt.

10. System (100) gemäß Anspruch 7, wobei die elektromagnetische Abschirmung (112) konfiguriert ist, um als eine Antenne für die Kommunikationsschaltung (126) zu wirken.

11. System (100) gemäß Anspruch 7,
wobei die Vorrichtung (200) zwischen einer Leistungsversorgung und elektrisch betriebener Ausrüstung gekoppelt ist, und
wobei die übertragene Nachricht einen Gesundheitszustand der Ausrüstung basierend auf einem analysierten Charakteristikum des ersten elektrischen Stroms beinhaltet.

12. System (100) gemäß Anspruch 11, wobei ein oder mehrere Charakteristika des ersten elektrischen Stroms Folgendes beinhalten: eine Stromaufnahme, eine Zykluszeit, Wirkleistung, Blindleistung und Stromvariabilität;
und/oder
wobei die erste Verarbeitungsschaltung für Folgendes konfiguriert ist:
Identifizieren von Parametern der Ausrüstung durch Analysieren der bestimmten Charakteristika des ersten Stromsignals;
Empfangen einer erwarteten Leistungsverbrauchssignatur von dem Server (136); und
Bestimmen eines Gesundheitszustands der Ausrüstung basierend auf dem Vergleichen der analysierten bestimmten Charakteristika des ersten Stromsignals mit der erwarteten Leistungsverbrauchssignatur.

13. Ein Verfahren, das Folgendes beinhaltet:
Ausgeben (700), durch eine Stromerfassungsschaltung (128), eines Signals, das Charakteristika eines ersten elektrischen Stroms identifiziert, der durch einen ersten elektrischen Leiter (110) einer Vielzahl von elektrischen Leitern (110, 108) fließt;
Empfangen (702), durch eine Verarbeitungsschaltung (122) einer Vorrichtung (200), des Signals von der Stromerfassungsschaltung (128), wobei die Vorrichtung (200) eine elektromagnetische Abschirmung (112) beinhaltet, die konfiguriert ist, um die Stromerfassungsschaltung (128) vom Erfassen eines zweiten elektrischen Stroms zu isolieren, der durch einen zweiten elektrischen Leiter (108) der Vielzahl von elektrischen Leitern (110, 108) fließt, wobei sich der zweite elektrische Leiter (108) vom ersten elektrischen Leiter (110) unterscheidet;
Bestimmen (704), durch die Verarbeitungsschaltung (122), der Charakteristika des ersten elektrischen Stroms basierend auf dem empfangenen Signal;
Vergleichen (706), durch die Verarbeitungsschaltung (122), der bestimmten Charakteristika mit einer oder mehreren Schwellengrenzen, die in dem Speicher (124) gespeichert sind;
basierend auf dem Vergleich, Bestimmen (708), durch die Verarbeitungsschaltung (122), ob die Kommunikationsschaltung (126), die mit der Verarbeitungsschaltung (122) gekoppelt ist, veranlasst werden soll, eine elektronische Nachricht basierend auf den Charakteristika des ersten elektrischen Stroms auszugeben; und
als Reaktion auf die Bestimmung, ob eine elektronische Nachricht basierend auf den Charakteristika des ersten elektrischen Stroms (708) ausgegeben werden soll,
Unterlassen des Veranlassens der Kommunikationsschaltung (126), die Nachricht auszugeben.

14. Verfahren gemäß Anspruch 13, wobei die elektromagnetische Abschirmung (112) konfiguriert ist, um als eine Antenne für die Kommunikationsschaltung (126) zu wirken; und/oder;
wobei der erste elektrische Strom elektrisch betriebene Ausrüstung betreibt und wobei die Nachricht Daten beinhaltet, die einen Gesundheitszustand der Ausrüstung basierend auf den Charakteristika des ersten elektrischen Stroms angeben.

15. Verfahren gemäß Anspruch 13,
wobei der erste elektrische Strom elektrisch betriebene Ausrüstung betreibt und wobei die Nachricht Daten beinhaltet, die einen Gesundheitszustand der Ausrüstung basierend auf den Charakteristika des ersten elektrischen Stroms angeben;
das ferner Folgendes beinhaltet:
Identifizieren von Parametern der Ausrüstung durch Analysieren der bestimmten Charakteristika des ersten elektrischen Stroms;
Empfangen einer erwarteten Leistungsverbrauchssignatur von einer externen Rechenvorrichtung (136); und
Bestimmen eines Gesundheitszustands der Ausrüstung basierend auf dem Vergleichen der analysierten bestimmten Charakteristika des ersten Stromsignals mit der erwarteten Leistungsverbrauchssignatur.

## Revendications

1. Un dispositif (200), comprenant :
une pluralité de conducteurs électriques (110, 108) configurés pour transporter une alimentation en courant alternatif (CA) ;
une circuiterie de détection de courant (128), la circuiterie de détection de courant (128) étant configurée pour délivrer en sortie un signal identifiant des caractéristiques d'un premier courant électrique circulant à travers un premier conducteur électrique (110) de la pluralité de conducteurs électriques (110, 108) ;
un blindage électromagnétique (112), configuré pour isoler la circuiterie de détection de courant (128) de la détection d'un deuxième courant électrique circulant à travers un deuxième conducteur électrique (108) de la pluralité de conducteurs électriques (110, 108), le deuxième conducteur électrique (108) étant différent du premier conducteur électrique (110) ;
une circuiterie de communication (126) configurée pour communiquer avec un dispositif informatique externe (136) distinct du dispositif (200) ;
une circuiterie de traitement (122) couplée de manière opérationnelle à la circuiterie de détection de courant (128) (128) et à une mémoire (124), la circuiterie de traitement (122) étant configurée pour :
recevoir le signal en provenance de la circuiterie de détection de courant (128) ;
déterminer les caractéristiques du premier courant électrique sur la base du signal ;
déterminer s'il convient d'amener la circuiterie de communication (126) à délivrer en sortie un message électronique sur la base des caractéristiques déterminées du premier courant électrique ;
comparer les caractéristiques déterminées à une ou plusieurs limites seuil stockées au niveau de la mémoire (124) ;
sur la base de la comparaison, déterminer s'il convient de délivrer en sortie un message au dispositif informatique externe (136) ; et
en réponse à la détermination s'il convient de délivrer en sortie un message au dispositif informatique externe (136), s'abstenir d'amener la circuiterie de communication (126) à délivrer en sortie le message.

2. Le dispositif (200) de la revendication 1, comprenant en outre une circuiterie de récupération d'énergie (129) couplée à au moins un conducteur électrique de la pluralité de conducteurs électriques (110, 108), la circuiterie de récupération d'énergie (129) étant configurée pour prélever de l'alimentation de l'au moins un conducteur électrique ;
et/ou
le dispositif (200) étant configuré pour être couplé entre un bloc d'alimentation et un équipement alimenté électriquement, et
dans lequel le message comprend des données indiquant un état de santé de l'équipement sur la base des caractéristiques du premier courant électrique ;
et/ou
dans lequel le blindage électromagnétique (112) est configuré pour agir comme antenne pour la circuiterie de communication (126).

3. Le dispositif (200) de la revendication 2, dans lequel la circuiterie de récupération d'énergie (129) est configurée pour prélever de l'alimentation d'un signal associé à la circuiterie de détection de courant (128).

4. Le dispositif (200) de la revendication 3, comprenant en outre un dispositif de stockage d'énergie (226) couplé électriquement à la circuiterie de récupération d'énergie (129), l'énergie récupérée par la circuiterie de récupération d'énergie (129) chargeant le dispositif de stockage d'énergie (226).

5. Le dispositif (200) de la revendication 1,
le dispositif (200) étant configuré pour être couplé entre un bloc d'alimentation et un équipement alimenté électriquement, et
dans lequel le message comprend des données indiquant un état de santé de l'équipement sur la base des caractéristiques du premier courant électrique, et
dans lequel une ou plusieurs caractéristiques du premier courant électrique comprennent : un prélèvement de courant, un temps de cycle, une puissance réelle, une puissance réactive et une variabilité de courant.

6. Le dispositif (200) de la revendication 5, dans lequel la circuiterie de traitement (122) est configurée pour :
identifier des paramètres de l'équipement en analysant les caractéristiques déterminées du premier courant électrique ;
recevoir une signature de consommation d'alimentation attendue en provenance du dispositif informatique externe (136) ; et
déterminer un état de santé de l'équipement sur la base d'une comparaison des caractéristiques déterminées analysées du premier courant électrique avec la signature de consommation d'alimentation attendue.

7. Un système (100) comprenant :
une passerelle (130) comprenant une première circuiterie de traitement couplée à une mémoire (124), la passerelle (130) étant configurée pour communiquer avec un serveur (136) ;
un dispositif (200), comprenant :
une pluralité de conducteurs électriques (110, 108) configurés pour transporter une alimentation en courant alternatif (CA) ;
une circuiterie de détection de courant (128), la circuiterie de détection de courant (128) étant configurée pour délivrer en sortie un signal identifiant des caractéristiques d'un premier courant électrique circulant à travers un premier conducteur électrique (110) de la pluralité de conducteurs électriques (110, 108) ;
un blindage électromagnétique (112), configuré pour isoler la circuiterie de détection de courant (128) de la détection d'un deuxième courant électrique circulant à travers un deuxième conducteur électrique (108) de la pluralité de conducteurs électriques (110, 108), le deuxième conducteur électrique (108) étant différent du premier conducteur électrique (110) ;
une circuiterie de communication (126) configurée pour communiquer avec la passerelle (130) ;
une deuxième circuiterie de traitement couplée de manière opérationnelle à la circuiterie de détection de courant (128), la deuxième circuiterie de traitement étant configurée pour :
recevoir le signal en provenance de la circuiterie de détection de courant (128) ;
déterminer les caractéristiques du premier courant électrique sur la base du signal ;
amener la circuiterie de communication (126) à délivrer en sortie un message à la passerelle (130), le message incluant les caractéristiques du premier courant électrique ;
la première circuiterie de traitement de la passerelle (130) est configurée pour :
recevoir le message avec les caractéristiques du premier courant électrique ; comparer les caractéristiques déterminées à une ou plusieurs limites seuil stockées au niveau de la mémoire (124) ;
sur la base de la comparaison, déterminer s'il convient de délivrer en sortie un message au serveur (136) ;
en réponse à la détermination s'il convient de délivrer en sortie un message au serveur (136), s'abstenir de délivrer en sortie le message.

8. Le système (100) de la revendication 7, le dispositif comprenant en outre une circuiterie de récupération d'énergie (129) couplée à au moins un conducteur électrique de la pluralité de conducteurs électriques (110, 108), la circuiterie de récupération d'énergie (129) étant configurée pour prélever de l'alimentation de l'au moins un conducteur électrique.

9. Le système (100) de la revendication 8, dans lequel la circuiterie de récupération d'énergie (129) est configurée pour prélever de l'alimentation d'un signal associé à la circuiterie de détection de courant (128) ;
et/ou ;
le système (100) comprenant en outre un dispositif de stockage d'énergie (226) couplé électriquement à la circuiterie de récupération d'énergie (129), l'énergie récupérée par la circuiterie de récupération d'énergie (129) chargeant le dispositif de stockage d'énergie (226).

10. Le système (100) de la revendication 7, dans lequel le blindage électromagnétique (112) est configuré pour agir comme antenne pour la circuiterie de communication (126).

11. Le système (100) de la revendication 7,
dans lequel le dispositif (200) est couplé entre un bloc d'alimentation et un équipement alimenté électriquement, et
dans lequel le message transmis comprend un état de santé de l'équipement sur la base d'une caractéristique analysée du premier courant électrique.

12. Le système (100) de la revendication 11, dans lequel une ou plusieurs caractéristiques du premier courant électrique comprennent : un prélèvement de courant, un temps de cycle, une puissance réelle, une puissance réactive et une variabilité de courant ; et/ou
dans lequel la première circuiterie de traitement est configurée pour :
identifier des paramètres de l'équipement en analysant les caractéristiques déterminées du premier signal de courant ;
recevoir une signature de consommation d'alimentation attendue en provenance du serveur (136) ; et
déterminer un état de santé de l'équipement sur la base d'une comparaison des caractéristiques déterminées analysées du premier signal de courant avec la signature de consommation d'alimentation attendue.

13. Un procédé comprenant :
la délivrance en sortie (700), par une circuiterie de détection de courant (128), d'un signal identifiant des caractéristiques d'un premier courant électrique circulant à travers un premier conducteur électrique (110) d'une pluralité de conducteurs électriques (110, 108) ;
la réception (702), par une circuiterie de traitement (122) d'un dispositif (200), du signal en provenance de la circuiterie de détection de courant (128), le dispositif (200) comprenant un blindage électromagnétique (112), configuré pour isoler la circuiterie de détection de courant (128) de la détection d'un deuxième courant électrique circulant à travers un deuxième conducteur électrique (108) de la pluralité de conducteurs électriques (110, 108), le deuxième conducteur électrique (108) étant différent du premier conducteur électrique (110) ;
la détermination (704), par la circuiterie de traitement (122), des caractéristiques du premier courant électrique sur la base du signal reçu ;
la comparaison (706), par la circuiterie de traitement (122), des caractéristiques déterminées avec une ou plusieurs limites seuil stockées au niveau de la mémoire (124) ;
sur la base de la comparaison, la détermination (708), par la circuiterie de traitement (122), s'il convient d'amener une circuiterie de communication (126) couplée à la circuiterie de traitement (122) à délivrer en sortie un message électronique sur la base des caractéristiques du premier courant électrique ; et
en réponse à la détermination s'il convient de délivrer en sortie un message électronique sur la base des caractéristiques du premier courant électrique (708),
l'abstention d'amener la circuiterie de communication (126) à délivrer en sortie le message.

14. Le procédé de la revendication 13, dans lequel le blindage électromagnétique (112) est configuré pour agir comme antenne pour la circuiterie de communication (126) ;
et/ou ;
dans lequel le premier courant électrique alimente un équipement alimenté électriquement, et
dans lequel le message comprend des données indiquant un état de santé de l'équipement sur la base des caractéristiques du premier courant électrique.

15. Le procédé de la revendication 13,
dans lequel le premier courant électrique alimente un équipement alimenté électriquement, et dans lequel le message comprend des données indiquant un état de santé de l'équipement sur la base des caractéristiques du premier courant électrique ; comprenant en outre :
l'identification de paramètres de l'équipement en analysant les caractéristiques déterminées du premier courant électrique ;
la réception d'une signature de consommation d'alimentation attendue en provenance d'un dispositif informatique externe (136) ; et
la détermination d'un état de santé de l'équipement sur la base d'une comparaison des caractéristiques déterminées analysées du premier signal de courant avec la signature de consommation d'alimentation attendue.
